# EUROPEAN PATENT APPLICATION

(11) **EP 4 411 803 A1**
(43) Date of publication of application: **07.08.2024**
(21) Application number: 22875386.9
(22) Date of filing: 14.03.2022
(51) Int. Cl.: H01L 23/12, H01L 21/56, H01L 21/60, H01L 27/146

(54) **IMAGING DEVICE, ELECTRONIC APPARATUS, AND METHOD FOR MANUFACTURING IMAGING DEVICE**

(30) Priority: 30.09.2021 JP 2021161007
(71) Applicant: Sony Semiconductor Solutions Corporation, Atsugi-shi, Kanagawa 243-0014 (JP)
(72) Inventor: NAKAGAWA, Kanae, Atsugi-shi, Kanagawa 243-0021 (JP); TAKAOKA, Yuji, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/011295
(87) International publication number: WO 2023/053503

(57) **Abstract**

In an imaging device, the device is reduced in size and height without deteriorating the imaging capability of an imaging element.

An imaging device includes: an imaging element having a pixel region and a peripheral region on the front side, the pixel region including multiple pixels, the peripheral region surrounding the pixel region; a rewiring layer that is provided on the front side of the imaging element and has an opening formed through a region including the pixel region; a sealing resin portion that is made of a sealing resin material and is provided to cover a portion around the imaging element and the back side of the rewiring layer; and a connecting portion that is provided on the peripheral region of the imaging element and electrically connects the imaging element and the rewiring layer.

## Description

### [Technical Field]

The present disclosure relates to an imaging device, an electronic device, and a method for manufacturing the imaging device.

### [Background Art]

Conventionally, an imaging device including an imaging element such as a CMOS image sensor mounted in, for example, an electronic device such as a smartphone is configured as follows: the imaging element is mounted on a circuit board (hereinafter will be simply referred to as "board") such as a ceramic substrate or a printed board, and the imaging element and the board are electrically connected to each other by wire bonding.

The number of connection pins of an imaging element in an imaging device has increased in recent years; meanwhile, pitches in the layout of connection pins have decreased in response to the need for downsizing of a package structure serving as an imaging device, resulting in difficulty in connection by wire bonding. Moreover, in the package structure of an imaging device, a height reduction (a size reduction in the height direction) has been demanded. However, in the foregoing configuration using connection by wire bonding, a height reduction is limited because of the thickness of the board.

Thus, a configuration is proposed such that a cavity is formed in a substrate and an imaging element is mounted in the cavity (for example, see PTL 1). Such a configuration may be reduced in height because the imaging element is placed in the cavity of the substrate but has disadvantages as follows:

First, the imaging element mounted in the cavity of the substrate tends to tilt with respect to the substrate. Moreover, in a configuration that includes an external connection terminal on the back side of a substrate having an imaging element thereon, the external connection terminal making electrical connection to a base substrate, on which an imaging device is mounted, via solder bumps, the imaging device may be tilted with respect to the base substrate by reflow treatment for melting solder. Furthermore, using the substrate with the cavity may cause higher cost as compared with an ordinary substrate free of cavities.

Thus, as disclosed in, for example, PTL 2, a package structure is proposed such that an imaging element is embedded in a sealing resin portion made of a sealing resin material and a rewiring layer is provided on the light receiving surface (sensor surface) of the imaging element. PTL 2 discloses a configuration in which a mold portion is formed as the sealing resin portion around the imaging element except for the pixel formation surface of the imaging element and the rewiring layer is provided on a surrounding region and the mold portion of the imaging element.

### [Citation List]

### [Patent Literature]

[PTL 1]
   JP 2008-235869A
[PTL 2]
   JP 2019-216187A

### [Summary]

### [Technical Problem]

In the configuration disclosed in PTL 2, the rewiring layer is formed to be directly connected to pads provided in the surrounding region of the imaging element. With this configuration, in the manufacturing process of an imaging device, the rewiring layer is formed for the configuration including the sealing resin portion formed around the imaging element. Thus, in the process of forming the rewiring layer, the pixel formation surface of the imaging element needs to be protected from, for example, a chemical solution used for forming the rewiring layer.

In order to protect the pixel formation surface of the imaging element, for example, a protective film may be formed on the pixel formation surface. However, when adopting such a method, if the temporarily formed protective film is insufficiently removed or a method of leaving the protective film is adopted, the protective film on the pixel formation surface may affect light transmission or the refractive index or the like of light and interfere with the function of the imaging element.

An object of the present technique is to provide an imaging device, an electronic device, and a method for manufacturing the imaging device, by which the device can be reduced in size and height without deteriorating the imaging capability of an imaging element.

### [Solution to Problem]

An imaging device according to the present technique includes: an imaging element having a pixel region and a peripheral region on the front side, the pixel region including multiple pixels, the peripheral region surrounding the pixel region; a rewiring layer that is provided on the front side of the imaging element and has an opening formed through a region including the pixel region; a sealing resin portion that is made of a sealing resin material and is provided to cover a portion around the imaging element and the back side of the rewiring layer; and a connecting portion that is provided on the peripheral region of the imaging element and electrically connects the imaging element and the rewiring layer.

According to another aspect of the imaging device of the present technique, in the imaging device, the rewiring layer includes a peripheral region covering portion that covers at least a part of the peripheral region of the imaging element in plan view, and the connecting portion is provided between the imaging element and the peripheral region covering portion.

According to another aspect of the imaging device of the present technique, in the imaging device, the imaging element is placed in a recessed portion formed on the sealing resin portion and is provided in the range of the layer thickness of the sealing resin portion.

According to another aspect of the imaging device of the present technique, the imaging device further includes an underfill portion that is made of a material different from the sealing resin material and covers the connecting portion.

According to another aspect of the imaging device of the present technique, in the imaging device, the imaging element has a step surface with a step lower than the pixel region in the peripheral region, and the connecting portion is provided on the step surface.

According to another aspect of the imaging device of the present technique, in the imaging device, the rewiring layer is formed such that a wall surface constituting the opening is a surface tilted to gradually extend the opening area of the opening from the front side to the back side of the rewiring layer.

According to another aspect of the imaging device of the present technique, in the imaging device, a partition portion for separating a space for placement of the connecting portion and a space for the pixel region is provided near the pixel region with respect to the connecting portion and between the rewiring layer and the imaging element.

According to another aspect of the imaging device of the present technique, the imaging device further includes a second rewiring layer that is provided near the back side of the imaging element with respect to the imaging element and the sealing resin portion and is electrically connected to the rewiring layer.

An electronic device according to the present technique includes an imaging device including: an imaging element having a pixel region and a peripheral region on the front side, the pixel region including multiple pixels, the peripheral region surrounding the pixel region; a rewiring layer that is provided on the front side of the imaging element and has an opening formed through a region including the pixel region; a sealing resin portion that is made of a sealing resin material and is provided to cover a portion around the imaging element and the back side of the rewiring layer; and a connecting portion that is provided on the peripheral region of the imaging element and electrically connects the imaging element and the rewiring layer.

A method for manufacturing an imaging device, the method including: preparing a support member having a release layer on one plate surface of a support substrate; forming a rewiring layer having an opening on the release layer, the opening exposing the release layer; providing the imaging element on the rewiring layer such that the imaging element covers the opening and is electrically connected to the rewiring layer while the front side of the imaging element faces the release layer; forming a sealing resin portion made of a sealing resin material such that the sealing resin portion is provided over the release layer of the rewriting layer and the opposite side to the release layer and around the imaging element; and peeling off the support substrate from the rewiring layer by the release layer.

According to another aspect of the method for manufacturing an imaging device of the present technique, the method for manufacturing the imaging device further includes reducing the thickness of the sealing resin portion from the opposite side to the rewiring layer after forming the sealing resin portion.

According to another aspect of the method for manufacturing an imaging device of the present technique, the method for manufacturing the imaging device further includes forming an underfill portion over the connecting portion by using a material different from the sealing resin material after providing the imaging element and before forming the sealing resin portion.

According to another aspect of the method for manufacturing an imaging device of the present technique, in the method for manufacturing the imaging device, in the forming of the rewiring layer, the rewiring layer is formed such that a wall surface constituting the opening is a surface tilted to gradually extend the opening area of the opening from the release layer to the opposite side to the release layer.

Another aspect of the method for manufacturing an imaging device of the present technique, the method for manufacturing the imaging device further includes, after forming the sealing resin portion, forming a second rewiring layer near the back side of the imaging element with respect to the imaging element and the sealing resin portion, the second rewiring layer being electrically connected to the rewiring layer.

### [Brief Description of Drawings]

[Fig. 1]

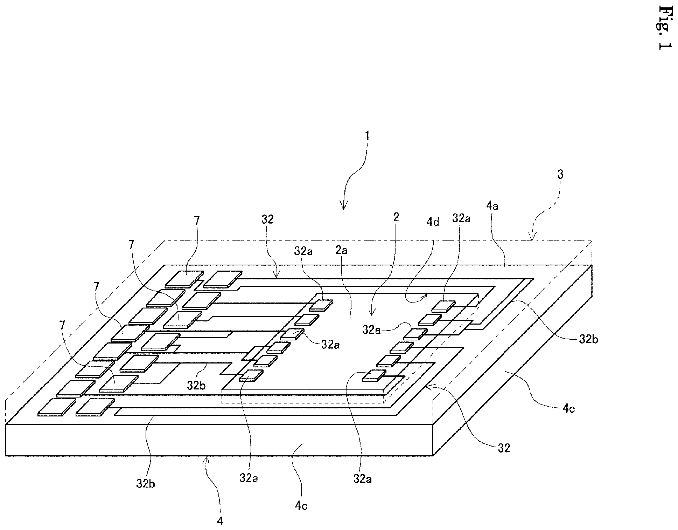

   Fig. 1 is a perspective view illustrating the configuration of a solid-state imaging device according to a first embodiment of the present technique.
[Fig. 2]

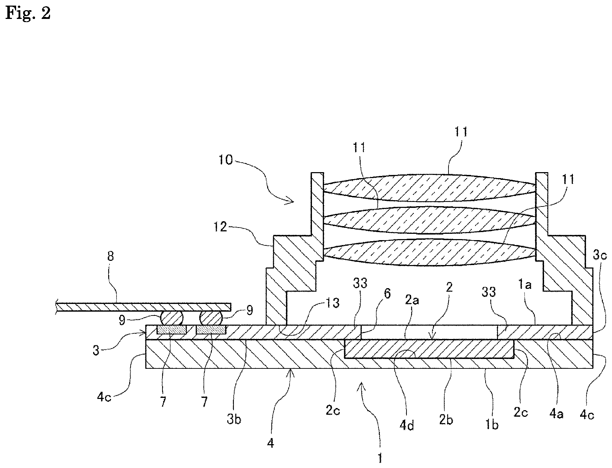

   Fig. 2 is a side cross-sectional view illustrating an application example of the solid-state imaging device according to the first embodiment of the present technique.
[Fig. 3]

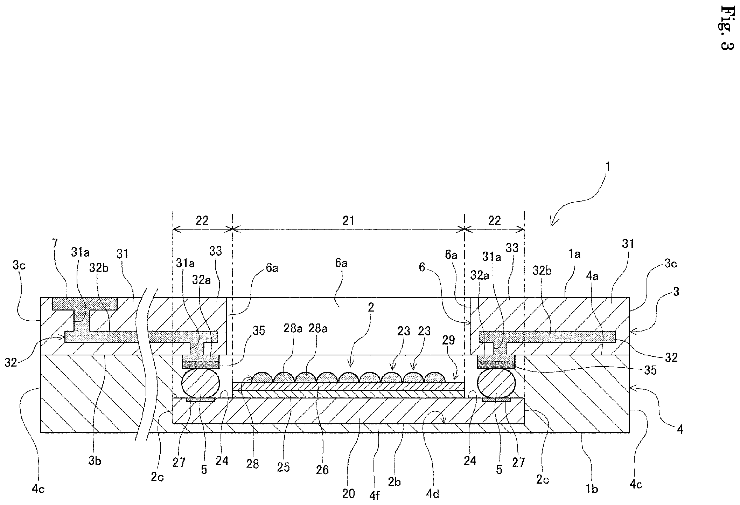

   Fig. 3 is a side cross-sectional view illustrating the configuration of the solid-state imaging device according to the first embodiment of the present technique.
[Fig. 4]

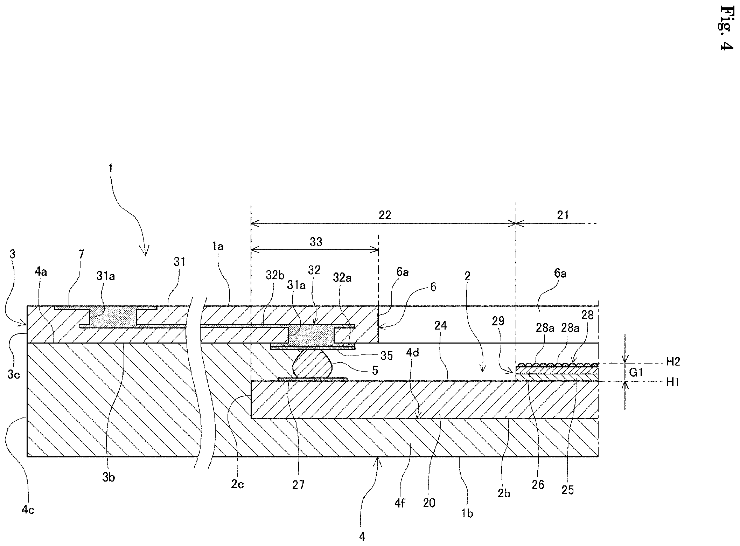

   Fig. 4 is a side cross-sectional view illustrating the configuration of a connecting portion between an image sensor and a rewiring layer in the solid-state imaging device according to the first embodiment of the present technique.
[Fig. 5]

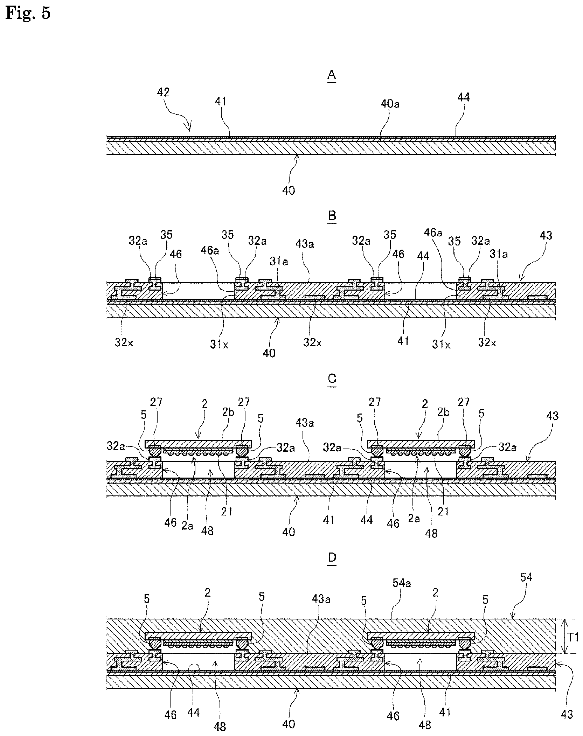

   Fig. 5 is an explanatory drawing illustrating a method for manufacturing the solid-state imaging device according to the first embodiment of the present technique.
[Fig. 6]

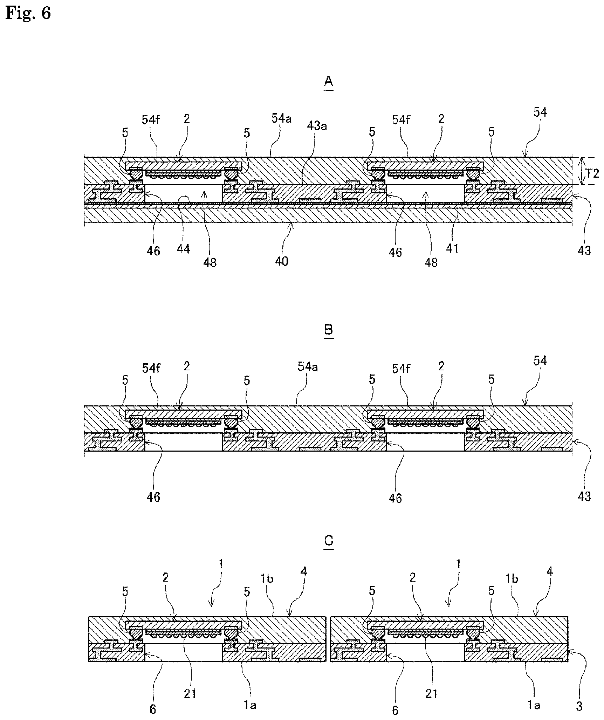

   Fig. 6 is an explanatory drawing illustrating the method for manufacturing the solid-state imaging device according to the first embodiment of the present technique.
[Fig. 7]

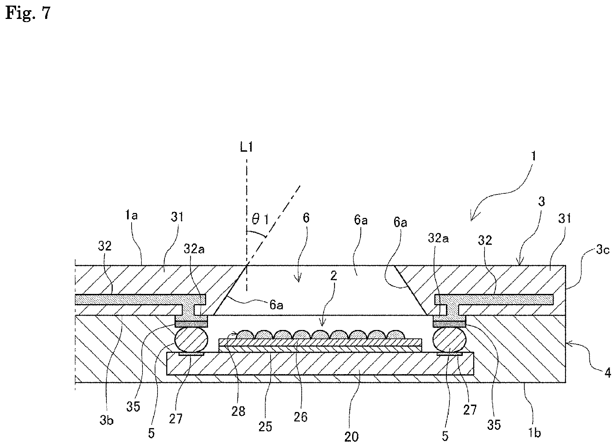

   Fig. 7 is a side cross-sectional view illustrating the configuration of a modification example of the solid-state imaging device according to the first embodiment of the present technique.
[Fig. 8]

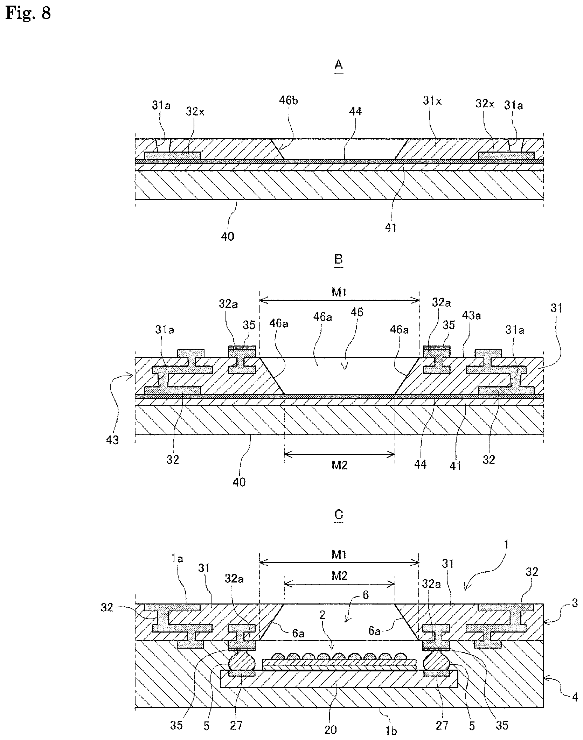

   Fig. 8 is an explanatory drawing illustrating the configuration of a modification example of the solid-state imaging device according to the first embodiment of the present technique.
[Fig. 9]

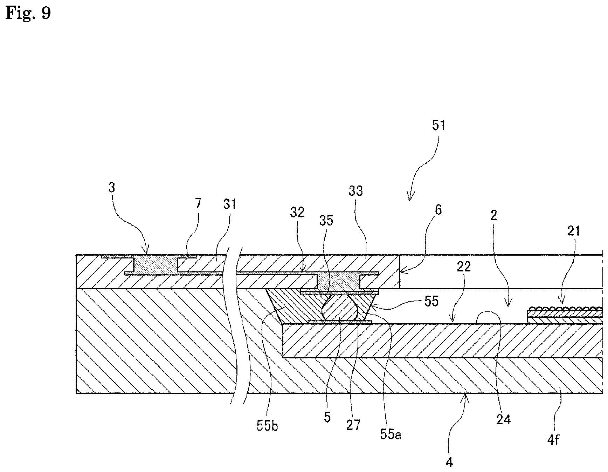

   Fig. 9 is a side cross-sectional view illustrating the configuration of a connecting portion between an image sensor and a rewiring layer in a solid-state imaging device according to a second embodiment of the present technique.
[Fig. 10]

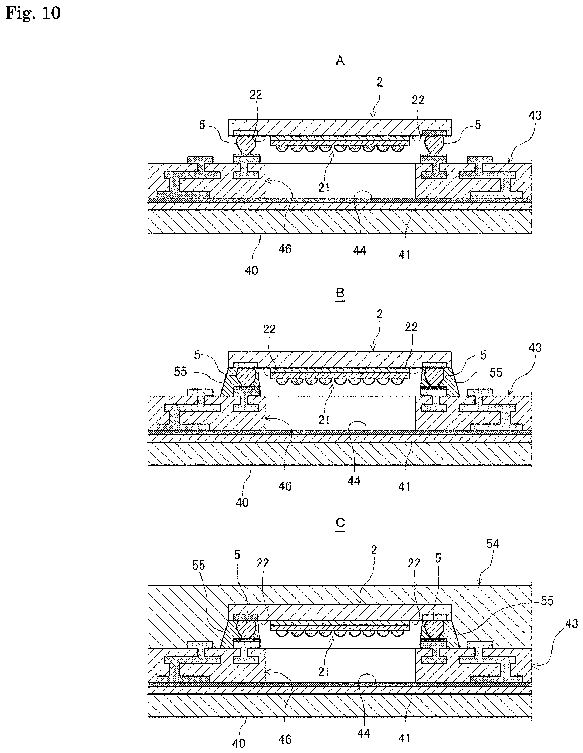

   Fig. 10 is an explanatory drawing illustrating a method for manufacturing the solid-state imaging device according to the second embodiment of the present technique.
[Fig. 11]

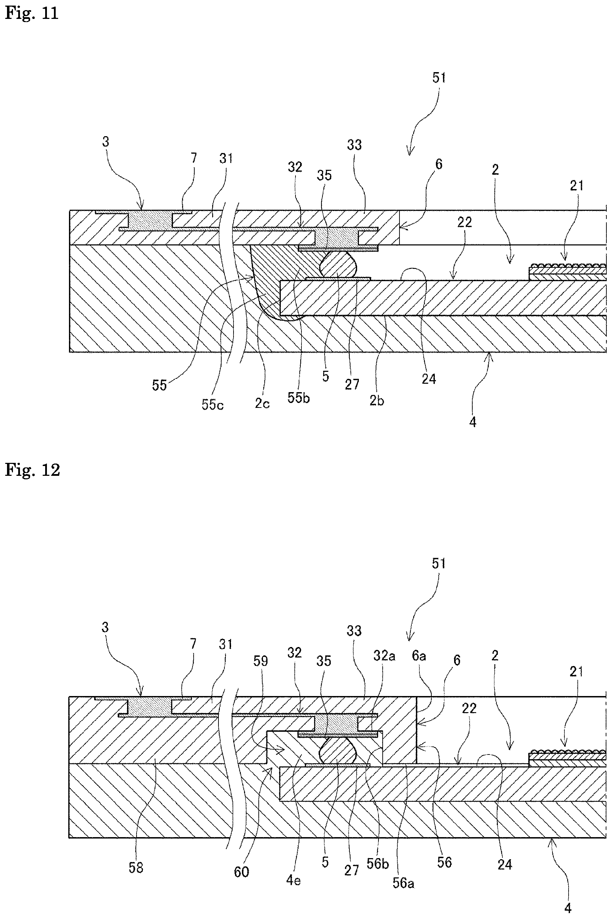

   Fig. 11 is a side cross-sectional view illustrating the configuration of a first modification example of the solid-state imaging device according to the second embodiment of the present technique.
[Fig. 12]
   Fig. 12 is a side cross-sectional view illustrating the configuration of a second modification example of the solid-state imaging device according to the second embodiment of the present technique.
[Fig. 13]

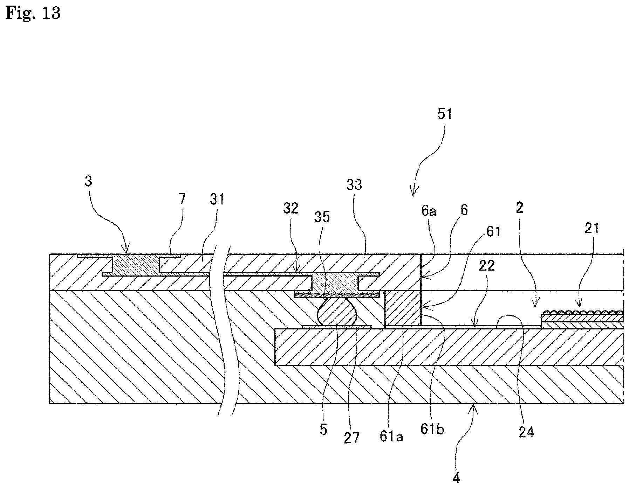

   Fig. 13 is a side cross-sectional view illustrating the configuration of a third modification example of the solid-state imaging device according to the second embodiment of the present technique.
[Fig. 14]

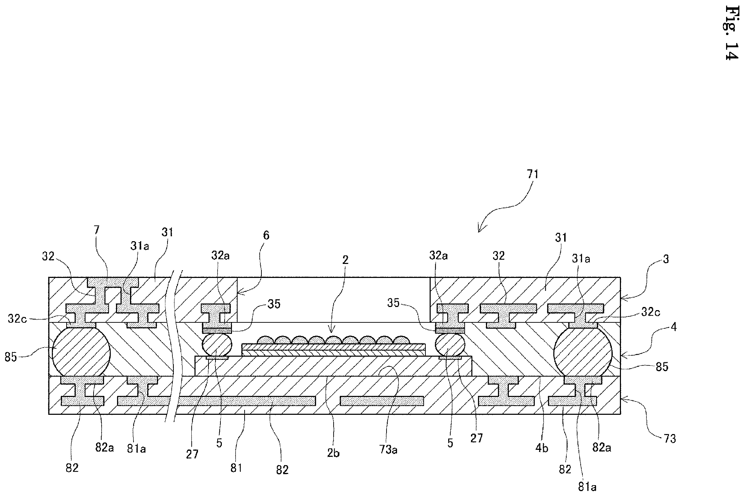

   Fig. 14 is a side cross-sectional view illustrating the configuration of a solid-state imaging device according to a third embodiment of the present technique.
[Fig. 15]

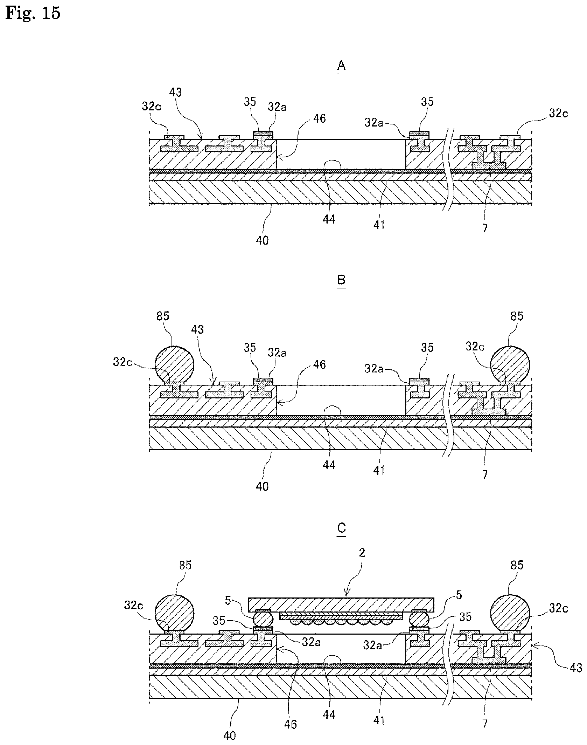

   Fig. 15 is an explanatory drawing illustrating a method for manufacturing the solid-state imaging device according to the third embodiment of the present technique.
[Fig. 16]

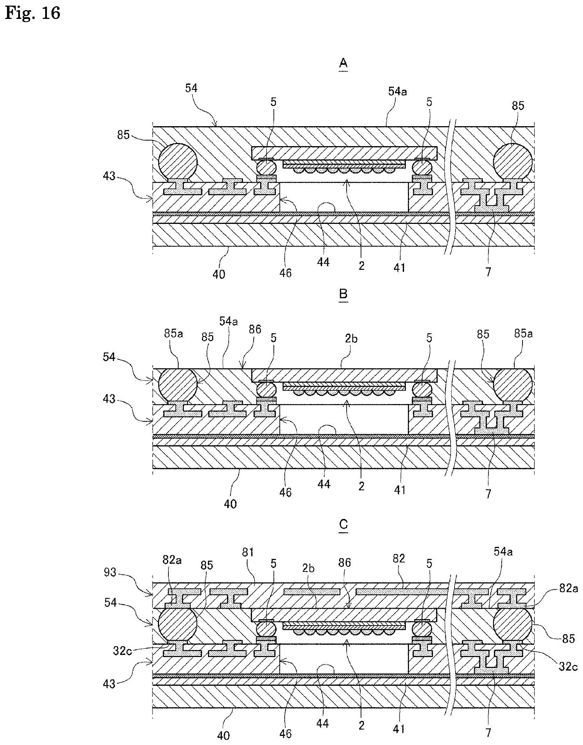

   Fig. 16 is an explanatory drawing illustrating the method for manufacturing the solid-state imaging device according to the third embodiment of the present technique.
[Fig. 17]

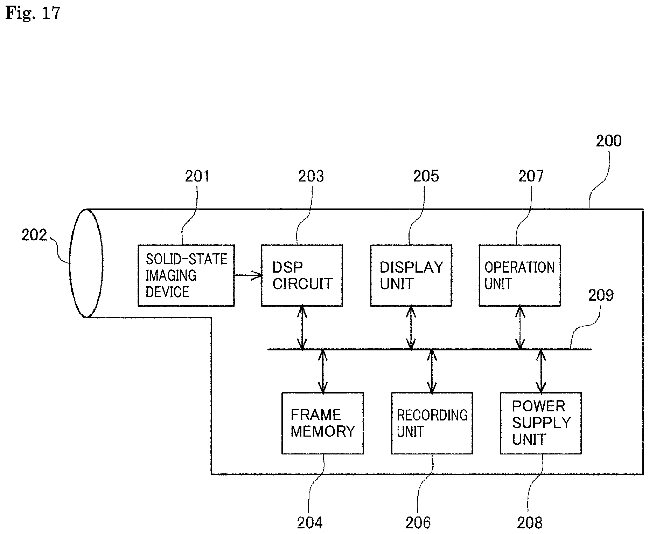

   Fig. 17 is a block diagram illustrating a configuration example of an electronic device including the solid-state imaging device according to the embodiments of the present technique.

### [Description of Embodiments]

In a configuration where an imaging element and a rewiring layer are integrated by a sealing resin portion made of a sealing resin material, the present technique is configured to reduce the size and height of a device while securing the imaging capability of the imaging element by devising an electrical connection configuration between the imaging element and the rewiring layer.

Modes for implementing the present technique (hereinafter referred to as "embodiments") will be described below with reference to the drawings. In the following embodiments, a solid-state imaging device including a solid-state imaging element as an example of an imaging element will be illustrated as an imaging device. The description of the embodiments will be made in the following order.
1. Configuration example of solid-state imaging device according to first embodiment
2. Method for manufacturing solid-state imaging device according to first embodiment
3. Modification example of solid-state imaging device according to first embodiment
4. Configuration example of solid-state imaging device according to second embodiment
5. Method for manufacturing solid-state imaging device according to second embodiment
6. Modification examples of solid-state imaging device according to second embodiment
7. Configuration example of solid-state imaging device according to third embodiment
8. Method for manufacturing solid-state imaging device according to third embodiment
9. Configuration example of electronic device

### <1. Configuration example of solid-state imaging device according to first embodiment>

Referring to Figs. 1 to 4, a configuration example of a solid-state imaging device 1 according to the present embodiment of a first technique will be described below. The vertical direction in Fig. 1 is the vertical direction of the solid-state imaging device 1.

As illustrated in Figs. 1 and 3, the solid-state imaging device 1 includes an image sensor 2 as a solid-state imaging element, a rewiring layer 3, a sealing resin portion 4, and metallic bumps 5 as connecting portions. The solid-state imaging device 1 has an outside shape like a substantially rectangular plate and has a front-side part 1a and a back-side part 1b, which are horizontal surface parts, and four side parts.

The solid-state imaging device 1 is provided such that the lower layer portion is mainly composed of the sealing resin portion 4, the upper layer portion is composed of the rewiring layer 3, and the image sensor 2 is embedded in the sealing resin portion 4. The image sensor 2 has a light receiving surface on the upper side, and the rewiring layer 3 has a wiring layer opening 6 as an opening for securing a path for light received by the image sensor 2. The solid-state imaging device 1 has a structure of so-called FOWLP (Fan Out Wafer Level Package) as a package structure, in which the image sensor 2 and the rewiring layer 3 are integrated by the sealing resin portion 4 serving as a mold resin portion and the rewiring layer 3 is extended outward from the outside shape of the image sensor 2.

In the solid-state imaging device 1, a plurality of external connection terminals 7 are formed on an edge of the front-side part 1a. The external connection terminals 7 are electrode portions that are formed as parts of rewiring constituting the rewiring layer 3 while being exposed on the front-side part 1a. In the example shown in Figs. 1 and 2, the image sensor 2 is provided at a position shifted to one side (the right side in Fig. 2) in the longitudinal direction (the lateral direction in Fig. 2) of the shape of the solid-state imaging device 1 in plan view. The plurality of external connection terminals 7 are provided on one end on the other side (the left side in Fig. 2) in the longitudinal direction of the solid-state imaging device 1.

As illustrated in Fig. 2, to the external connection terminals 7, for example, one end of a flexible substrate 8 referred to as an FPC (Flexible Printed Circuits) or the like is electrically connected via connecting portions 9 formed by solder plating. The other end of the flexible substrate 8 is provided with a connector, and the other end of the flexible substrate 8 is connected to a predetermined external device.

As illustrated in Fig. 2, the solid-state imaging device 1 is loaded with a lens unit 10 on the front-side part 1a. The lens unit 10 forms, on the image sensor 2, an image of light from a subject through a plurality of lenses 11. The lens unit 10 has a support cylinder 12 configured like a tube and supports the plurality of lenses 11 in the support cylinder 12. In the example illustrated in Fig. 2, the support cylinder 12 supports the three lenses 11 vertically stacked with spacers or the like while the direction of the cylinder axis is extended along the direction of the optical axis of the lens unit 10. The optical axis of the lens unit 10 is a vertical straight line passing through the centers of the three lenses 11. The number of lenses 11 is not particularly limited.

The lens unit 10 is mounted on the solid-state imaging device 1 while a mounting surface 13 on the underside of the support cylinder 12 is fixed onto the front-side part 1a of the solid-state imaging device 1 with an adhesive or the like. In the configuration where the lens unit 10 is provided on the solid-state imaging device 1, light condensed through the plurality of lenses 11 enters the light receiving surface of the image sensor 2. Configurations provided in the imaging device 1 will be described below.

The image sensor 2 is electrically connected to the rewiring layer 3. The image sensor 2 is a semiconductor element including a semiconductor substrate made of silicon (Si), an example of a semiconductor. As illustrated in Fig. 2, the image sensor 2 is a chip like a rectangular plate that has a front side 2a serving as a light receiving surface on the upper plate surface and a back side 2b on the opposite plate surface. Moreover, the image sensor 2 has four side portions 2c vertically formed with respect to the plate surface.

The image sensor 2 has a smaller plate thickness than the layer thickness of the sealing resin portion 4 and is provided while being embedded in the sealing resin portion 4 with the exposed front side 2a. The image sensor 2 has outside dimensions larger than the opening dimensions of the wiring layer opening 6 in plan view and has a peripheral portion placed under the opening edge portion of the wiring layer opening 6 of the rewiring layer 3.

On the front side 2a of the image sensor 2, a plurality of light receiving elements (photoelectric conversion elements) are formed. The image sensor 2 according to the present embodiment is a CMOS (Complementary Metal Oxide Semiconductor) image sensor. However, the image sensor 2 may be another imaging element, e.g., a CCD (Charge Coupled Device) image sensor.

As illustrated in Figs. 3 and 4, near the front side 2a, the image sensor 2 has a pixel region 21 that is a light receiving region having multiple pixels 23 and a peripheral region 22 that is a region surrounding the pixel region 21. In the pixel region 21, the multiple pixels 23 are formed in a predetermined array, for example, a Bayer array and constitutes a light receiving portion in the image sensor 2. In the peripheral region 22, a predetermined peripheral circuit is formed. The pixel region 21 includes an effective pixel region in which a signal charge is generated, amplified, and read by photoelectric conversion in the pixels 23.
The pixels 23 of the pixel region 21 each include a photodiode as a photoelectric conversion unit having a photoelectric conversion function and a plurality of pixel transistors. The photodiodes are formed on a semiconductor substrate 20.

In the image sensor 2, a plurality of pad electrodes 27 serving as electrode terminals for external connection are formed in the peripheral region 22 on the front side 2a. The pad electrodes 27 are portions electrically connected to the rewiring layer 3 via the metallic bumps 5. In the image sensor 2, the plurality of pad electrodes 27 are provided on, for example, both edges opposed to each other in the longitudinal direction of the solid-state imaging device 1.

Examples of the configuration of the image sensor 2 include a front side illumination type in which the pixel region 21 is formed on the front side of the semiconductor substrate 20, a back side illumination type in which photodiodes or the like are reversely disposed to improve the transmittance of light and the back side of the semiconductor substrate 20 serves as a light receiving surface, and a single chip in which the peripheral circuits of pixels are stacked. However, the image sensor 2 according to the present technique is not limited to these configurations.

In the present embodiment, the image sensor 2 has a step surface 24 with a step lower than the pixel region 21 in the peripheral region 22. Specifically, the peripheral region 22 has the step surface 24 with a step lower than the pixel region 21, and the flat step surface 24 lower than the top surface portion of the pixel region 21 is provided as the top surface of the peripheral region 22. Thus, a step portion is formed between the pixel region 21 and the peripheral region 22.

A configuration example of the image sensor 2 having the step surface 24 will be described below. On the top surface of the semiconductor substrate 20, that is, one of the plate surfaces of the semiconductor substrate 20, a planarization film 25 having optical transparency is provided with an insulating film interposed between the top surface and the planarization film 25. The insulating film is, for example, a silicon oxide film acting as an antireflection film. The planarization film 25 is made of, for example, organic materials such as an insulating resin. On the planarization film 25, a color filter layer 26 divided into a plurality of color filters provided for the respective pixels 23 is provided.

On the color filter layer 26, a lens layer 28 is formed with a plurality of microlenses 28a formed for the photodiodes of the pixels 23. The lens layer 28 is made of, for example, organic materials such as a resin. Light incident on the microlenses 28a is received by the photodiodes through the color filter layer 26 and the planarization film 25.

As described above, in the pixel region 21, a laminated structure 29 including the planarization film 25, the color filter layer 26, and the lens layer 28 is provided on the top surface of the semiconductor substrate 20. Depending upon the configuration of the image sensor 2, a wiring layer including a plurality of wires stacked with an interlayer insulating film interposed therebetween is provided on the underside of the semiconductor substrate 20, the interlayer insulating film being formed by a silicon oxide film or the like.

On the front side 2a of the image sensor 2 configures thus, only the pixel region 21 serves as the formation region of the laminated structure 29 formed on a top surface 20a of the semiconductor substrate 20, and the top surface of the semiconductor substrate 20 is exposed as the step surface 24 in the peripheral region 22, so that a step G1 is formed between the pixel region 21 and the peripheral region 22. In other words, as illustrated in Fig. 4, the laminated structure 29 is selectively formed in the pixel region 21, so that the pixel region 21 is increased in layer thickness upward with respect to the peripheral region 22, in which the top surface of the semiconductor substrate 20 is exposed, according to the layer thickness of the laminated structure 29 and forms the step G1. Therefore, the step G1 has a dimension between a height position H1 of the step surface 24 and a height position H2 of the upper end of the lens layer 28 in the thickness direction (vertical direction) of the image sensor 2.

As described above, in the image sensor 2, the peripheral region 22 having a small thickness is provided to form a step on the front side 2a with respect to the pixel region 21. The peripheral region 22 is provided over the outer edge of the image sensor 2 along the rectangular outside shape of the image sensor 2.

The sealing resin portion 4 is made of a predetermined sealing resin material and is provided to cover a portion surrounding the image sensor 2 and a back side 3b of the rewiring layer 3. The sealing resin portion 4 constitutes a lower layer portion under the rewiring layer 3 in the solid-state imaging device 1 and forms an outside shape of the lower part of the solid-state imaging device 1.

On the sealing resin portion 4, a contact surface with the rewiring layer 3 serves as a top surface 4a. Moreover, the undersurface portion of the sealing resin portion 4 serves as the back-side part 1b of the solid-state imaging device 1. Thus, the sealing resin portion 4 has a chip backside portion 4f formed on the back side 2b of the image sensor 2. Furthermore, four sides 4c of the sealing resin portion 4 form the lower parts of the four side parts of the solid-state imaging device 1.

The sealing resin portion 4 as a mold portion provides sealing over the back side 2b and the four side portions 2c of the image sensor 2, the back side 3b of the rewiring layer 3, and the outside of the connecting portion of the image sensor 2 and the rewiring layer 3 via the metallic bumps 5. The sealing resin portion 4 applies a coating around the image sensor 2 from the peripheral portion to the lower side of the image sensor 2 while exposing at least a part of the pixel region 21 on the front side 2a of the image sensor 2.

The sealing resin portion 4 is formed into a predetermined shape by, for example, molding using a mold die. The sealing resin material for forming the sealing resin portion 4 is, for example, a thermosetting resin containing a filler mainly composed of silicon oxide.

The image sensor 2 is placed in a recessed portion 4d formed on the sealing resin portion 4 and is provided in the range of the layer thickness of the sealing resin portion 4. On the sealing resin portion 4 covering, from the underside, the overall rewiring layer 3 and the overall image sensor 2 placed lower than the rewiring layer 3, the recessed portion 4d having a transfer shape corresponding to the shape of the connecting portion of the image sensor 2 and the metallic bumps 5 is formed on the lower side of the wiring layer opening 6.

Thus, the recessed portion 4d is formed to include surfaces in contact with the overall back side 2b and the overall four side portions 2c of the image sensor 2 and the overall back side 3b of the rewiring layer 3, and a surface covering the outside of the connecting portion of the image sensor 2 and the rewiring layer 3 via the metallic bumps 5. The latter surface includes, for example, the peripheral portion of the front side 2a of the image sensor 2 and the outside of the metallic bumps 5, that is, the surface of the outer side with respect to the pixel region 21 as the inner side of the image sensor 2.

The image sensor 2 is embedded in the sealing resin portion 4 in such a manner as to be fit into the recessed portion 4d of the sealing resin portion 4 while exposing a portion other than the peripheral portion of the front side 2a. Moreover, the image sensor 2 is provided such that the height position of the front side 2a is set at the height position of the top surface 4a of the sealing resin portion 4 or lower. Specifically, the height position H2 (see Fig. 4) of the upper end of the lens layer 28 in the image sensor 2 is set at the height position of the top surface 4a of the sealing resin portion 4 or lower.

However, the image sensor 2 may be provided such that the height position of the front side 2a is higher than the top surface 4a of the sealing resin portion 4 and the upper side of the image sensor 2 is partially placed in the wiring layer opening 6. In other words, the image sensor 2 may be provided such that the upper side of the image sensor 2 is partially placed in the range of the layer thickness of the rewiring layer 3.

The rewiring layer 3 is provided on the front side 2a of the image sensor 2 and has the wiring layer opening 6 formed through a region including the pixel region 21. The rewiring layer 3 is formed as a laminated wiring layer including a plurality of wiring layers 32 stacked via an interlayer insulating film 31.

On the rewiring layer 3, a contact surface with the sealing resin portion 4 serves as the back side 3b. Moreover, a top surface portion serving as the front-side part of the rewiring layer 3 serves as the front-side part 1a of the solid-state imaging device 1. Furthermore, four sides 3c of the rewiring layer 3 form the upper parts of the four side parts of the solid-state imaging device 1. The upper and lower sides of the rewiring layer 3 are substantially entirely formed by the interlayer insulating film 31.

The interlayer insulating film 31 is made of resin materials such as epoxy resin and polyimide or is formed by, for example, a silicon oxide film or a silicon nitride film. The wiring layer 32 is formed as a metallic film made of metallic materials such as Al (aluminum), Au (gold), Ag (silver), Cu (copper), and tungsten (W). The stacked interlayer insulating film 31 and wiring layers 32 may be made of the same material or different materials.

The external connection terminal 7 is formed by the uppermost layer portion of the wiring layer 32 constituting the rewiring layer 3. Moreover, lower electrodes 32a, to which the metallic bumps 5 are connected, are formed by the lowermost portions of the wiring layer 32. The lower electrodes 32a are electrode portions that are formed while being exposed on the back side 3b of the rewiring layer 3. The lower electrodes 32a are provided at multiple points according to the layout of the metallic bumps 5.

The wiring layers 32 provided in the rewiring layer 3 each include the external connection terminal 7 formed on one end, the lower electrode 32a formed on the other end, and a wiring portion 32b connecting the external connection terminal 7 and the lower electrode 32a. The wiring portion 32b is formed to include layered portions formed as wiring layers and a connecting portion vertically connecting the layered portions. The connecting portion of the wiring portion 32b is a portion formed in a connection via hole 31a that is formed in the layer thickness direction in the interlayer insulating film 31. The rewiring layer 3 may be a wiring layer having a single-layer structure.

The wiring layer opening 6 is formed through the rewiring layer 3 into a rectangular opening according to the shape of the image sensor 2 in plan view by four inner surfaces 6a vertically formed with respect to the back side 3b. The four inner surfaces 6a are made of a material that forms the interlayer insulating film 31 constituting the rewiring layer 3. However, the wiring layer 32 may be partially exposed on the inner surface 6a.

The wiring layer opening 6 is formed such that the opening region of the wiring layer opening 6 includes the overall pixel region 21 of the image sensor 2 in plan view and the peripheral portion of the image sensor 2 is placed outside the opening region. In other words, the wiring layer opening 6 is formed such that the four inner surfaces 6a are placed outside the pixel region 21 and inside the side portions 2c of the image sensor 2.

The rewiring layer 3 includes a peripheral region covering portion 33 that covers at least a part of the peripheral region 22 of the image sensor 2 in plan view. The rewiring layer 3 has the peripheral region covering portion 33 at the opening edge portion of the wiring layer opening 6. In other words, the peripheral region covering portion 33 is a regional portion in the planar direction of the rewiring layer 3 and is formed as an opening edge portion that forms the wiring layer opening 6.

The peripheral region covering portion 33 is a portion protruding like a hood into the pixel region 21 with respect to the sealing resin portion 4 above the recessed portion 4d of the sealing resin portion 4. The peripheral region covering portion 33 is formed like a frame along the outside shape of the image sensor 2. In other words, the peripheral region covering portion 33 is provided to cover the peripheral region 22 from above, the peripheral region 22 being formed like a frame in the image sensor 2 in plan view.

The peripheral region covering portion 33 has the back side 3b facing the step surface 24, above the step surface 24 of the image sensor 2. The lower electrodes 32a are formed on the peripheral region covering portion 33. The lower electrodes 32a on the peripheral region covering portion 33 are formed to face the pad electrodes 27 of the image sensor 2.

The metallic bumps 5 are connection bumps that are provided on the peripheral region 22 of the image sensor 2 and electrically connect the image sensor 2 and the rewiring layer 3. The metallic bumps 5 are provided between the image sensor 2 and the peripheral region covering portion 33 of the rewiring layer 3. In the present embodiment, the metallic bumps 5 are provided on the step surface 24 on the front side 2a of the image sensor 2 and are interposed between the step surface 24 and a portion of the peripheral region covering portion 33 on the back side 3b of the rewiring layer 3.

The metallic bumps 5 are protruding terminals that are made of a conductive material and electrically connect the pad electrodes 27 on the image sensor 2 and the lower electrodes 32a on the rewiring layer 3. The metallic bumps 5 between the image sensor 2 and the rewiring layer 3 form a gap between the front side 2a (step surface 24) of the image sensor 2 and the back side 3b of the rewiring layer 3. The size of the gap, that is, the height of the metallic bumps 5 is, for example, about several tens micrometers.

The metallic bumps 5 are provided at certain intervals in multiple arrays according to the number of pad electrodes 27 formed on the front side 2a of the image sensor 2. The metallic bumps 5 constitute a connecting portion between the image sensor 2 and the rewiring layer 3 and are partially covered with the sealing resin portion 4 that provides sealing between the image sensor 2 and the rewiring layer 3 from the outside, and the material of the sealing resin portion 4 is placed between the bumps. The metallic bumps 5 are, for example, Au stud bumps, solder ball bumps, or Au-Ag alloy bumps.

On the lower electrode 32a to which the metallic bump 5 is connected, a plating layer 35 is formed. For example, if the metallic bumps 5 are Au stud bumps, the plating layer 35 is a layer formed by Au displacement plating.

In the present embodiment, the metallic bumps 5 are provided as connecting portions between the image sensor 2 and the rewiring layer 3. The connecting portions may be, for example, metallic posts such as Cu pillars.

### <2. Method for manufacturing solid-state imaging device according to first embodiment>

Referring to Figs. 5 and 6, an example of a method for manufacturing the solid-state imaging device 1 according to the first embodiment will be described below.

In the method for manufacturing the solid-state imaging device 1, a rewiring layer including a plurality of portions serving as the rewiring layers 3 in the solid-state imaging devices 1 is formed on a predetermined support substrate, a plurality of chips for the image sensors 2 are mounted on the rewiring layer, a dummy wafer having a predetermined shape is prepared by sealing the plurality of chips with resin, and then the wafer is divided into pieces, so that the solid-state imaging device 1 is obtained. In the present manufacturing method, before the image sensor 2 and the rewiring layer 3 are integrated by a sealer, steps are performed on the support substrate serving as a temporary carrier. Thereafter, the support substrate is separated from the device and the wafer is divided into pieces, so that the solid-state imaging device 1 is obtained. Thus, a release layer is formed on the support substrate.

In the method for manufacturing the solid-state imaging device 1, first, the step of preparing a support substrate 40 is performed as illustrated in Fig. 5A. The support substrate 40 is a temporary carrier that is temporarily used in the manufacturing process and is a member to be peeled off and removed in the end. The support substrate 40 is a flat-shaped member having a flat top surface 40a as one plate surface.

The support substrate 40 is not particularly limited if predetermined supporting strength is provided. As the support substrate 40, for example, a plate made of inorganic materials such as glass, ceramics, metals, and silicon or plastics is used.

Thereafter, the step of forming a release layer 41 on the top surface 40a of the support substrate 40 is performed as illustrated in Fig. 5A. The release layer 41 is a layer located between the support substrate 40 and a device structure formed on the surface (top surface 40a). The release layer 41 is located to separate the support substrate 40 and the device structure after the device structure is formed. The device structure includes, for example, a semiconductor element, a wiring material, an insulating material, and a sealing material. In the present embodiment, the device structure formed on the support substrate 40 is a rewiring layer 43.

The release layer 41 is formed by applying a separating material, which forms the release layer 41, onto the top surface 40a of the support substrate 40. The release layer 41 may be formed by bonding a sheet member, e.g., release tape to the top surface 40a of the support substrate 40. Through this step, a support member 42 is obtained with the release layer 41 formed on the top surface 40a of the support substrate 40. In other words, in this step, the support member 42 is prepared with the release layer 41 on one plate surface of the support substrate 40.

The requirements of the release layer 41 are described below.
(1) The support substrate 40 and the device structure are not peeled off when the device structure is formed.
(2) The device structure is not damaged when the device structure is peeled off from the support substrate 40.

As for (2), methods for peeling off the release layer 41 are described below.
(A) Mechanical exfoliation: exfoliation with a blade or the like
(B) Chemical reaction: light or heat or the like
(C) Physical reaction: laser ablation or the like

In the case of the release layer 41 of (B) and (C), the state of a material constituting the release layer 41 is changed by external energy, so that the support substrate 40 and the device structure can be separated from each other. Used as a separating material is, for example, a material that is easily peeled off (reduced in adhesion) by irradiation of light such as UV (ultraviolet) light or a laser beam or heating. A separating material with UV easy peeling properties acts as, for example, an adhesive that has adhesion to be reduced by UV irradiation. As a separating material, for example, photo-curable materials such as a UV curable resin can be also used.

In the use of a material that is easily peeled off by irradiation of light, a substrate made of an optically transparent material, for example, a glass or transparent plastic plate is used as the support substrate 40. Specifically, for example, when UV light is used in the exfoliation of the release layer 41, a glass wafer having high transparency to the wavelength of UV light is used as the support substrate 40.

Thereafter, as illustrated in Fig. 5B, the step of forming the rewiring layer 43 with a cavity on the release layer 41 is performed. The rewiring layer 43 has an opening 46, in which the release layer 41 is exposed, as a cavity. The rewiring layer 43 is a portion constituting the rewiring layer 3 in the solid-state imaging device 1 obtained by dividing the wafer. The opening 46 is a portion serving as the wiring layer opening 6 of the rewiring layer 3 in the solid-state imaging device 1 and is formed by for inner surfaces 46a.

In the step of forming the rewiring layer 43, except for a portion corresponding to the opening 46, a predetermined number of insulating films and wiring layers that constitute the layers of the interlayer insulating film 31 and the wiring layer 32 in the solid-state imaging device 1 are stacked and formed. For the formation of the rewiring layer 43, for example, known methods such as a semi-additive process, an additive process (fully-additive process), and a damascene process are used.

When the formation of the rewiring layer 43 is formed, as illustrated in Fig. 5A, a mask layer 44 is formed on the release layer 41. The mask layer 44 is a layer for blocking light affecting the release layer 41 when a photolithography process is used in the step of forming the rewiring layer 43.

The mask layer 44 is, for example, a metallic layer made of metals such as Al. However, the mask layer 44 may be a layer made of a resin material that is not transparent to light such as UV light in addition to inorganic materials such as metals. If the release layer 41 is affected by a chemical solution used for forming the rewiring layer 43, in order to protect the release layer 41 from the chemical solution, a mask layer for a chemical solution for the protection is provided. As the mask layer 44 for shielding light and the mask layer for the chemical solution, a single layer may be shared or separate layers may be provided.

In the formation of the rewiring layer 43, a first wiring layer 32x is initially formed. Specifically, a seed layer made of, for example, metallic materials such as Cu is formed on the mask layer 44, and a resist mask is formed on the seed layer by patterning using a photolithography technique. After patterning of a resist, a metallic material is built up to a desired thickness on the seed layer by plating such as electroplating, so that a metallic layer is formed as the wiring layer 32x. Thereafter, the resist mask and unnecessary portions of the seed layer are removed to form the wiring layer 32x.

An insulating film 31x is subsequently formed. As a material of the insulating film 31x, for example, a photosensitive resin material such as photosensitive polyimide is used. In this case, a hole portion for forming the opening 46 and the connection via hole 31a are formed by a photolithography process. As a material of the insulating film 31x, for example, a non-photosensitive material such as epoxy resin may be used. In this case, the opening 46 and the connection via hole 31a are formed by using, for example, a laser.

The step of forming the wiring layer 32x and the step of forming the insulating film 31x are repeated to form the rewiring layer 43 that is a laminated wiring layer having a desired number of layers. The wiring layer and the insulating film that constitute the rewiring layer 43 each have a layer thickness (film thickness) of about several to more than ten micrometers. The rewiring layer 43 has a front-side portion 43a as a surface part on the side opposite to the support substrate 40.

As a metallic material used for the mask layer 44, a material different from the metallic material of the wiring layer of the rewiring layer 43 is used. Depending upon the process, the seed layer can be used as the mask layer. Specifically, for example, if the mask layer 44 is provided as a layer in contact with the material of the insulating film 31x of the rewiring layer 43, the seed layer is used as the mask layer. If a material that is easily peeled off by heating at a predetermined temperature is used as the separating material of the release layer 41, a temperature lower than the predetermined temperature needs to be kept from the step of forming the rewiring layer 43 to the sealing step, which will be described later.

As illustrated in Fig. 5B, in the rewiring layer 43, the lower electrodes 32a to which the metallic bumps 5 are connected are formed around the opening 46 as the wiring layer of the outermost layer (the uppermost layer in Fig. 5B). On the lower electrode 32a, the plating layer 35 is formed by, for example, Au displacement plating. The formation of the plating layer 35 can be omitted depending upon a combination of the materials of the lower electrodes 32a and the metallic bumps 5.

Thereafter, as illustrated in Fig. 5C, the step of mounting the image sensor 2 is performed. The step of providing the image sensor 2 on the rewiring layer 43 is performed such that the image sensor 2 covers the opening 46 and is electrically connected to the rewiring layer 43 while the front side 2a of the image sensor 2 faces the release layer 41.

In this step, the image sensor 2 is provided in a so-called face-down state with respect to the rewiring layer 43 so as to cover the opening 46 in plan view while the front side 2a serving as a pixel formation surface is directed toward the rewiring layer 43. The image sensor 2 is electrically connected to the rewiring layer 43 via the metallic bumps 5 interposed between the image sensor 2 and the rewiring layer 43.

In the mounting of the image sensor 2, the metallic bumps 5 are formed in advance on the pad electrodes 27 in the image sensor 2. In the step of forming the metallic bumps 5, Au stud bumps as the metallic bumps 5 are formed on the pad electrodes 27 by using, for example, a wire bonding device. If metallic posts such as Cu pillars are used instead of the metallic bumps 5, for example, cylindrically protruding portions made of materials such as Cu and a Cu alloy are formed as the metallic posts on the pad electrodes 27 by plating, sputtering, or vapor deposition or the like.

The image sensor 2 is mounted such that the tips of the metallic bumps 5 are placed on the plating layer 35 on the lower electrodes 32a of the rewiring layer 43, and the metallic bumps 5 are bonded to the lower electrodes 32a via the plating layer 35. If the action of heating is used in the step of bonding the metallic bumps 5 to the lower electrodes 32a, the heating temperature is adjusted to or below a predetermined temperature in consideration of the heatproof temperatures of the image sensor 2 and the release layer 41.

The heights of the metallic bumps 5 and the metallic posts are desirably minimized in view of the height reduction and cost reduction of the solid-state imaging device 1. For example, the metallic bumps 5 and the metallic posts are desirably several tens micrometers in height. Moreover, the heights of the metallic bumps 5 and the metallic posts are desirably minimized in view of the prevention of entry of a sealing resin material, which will be described later, into the pixel region 21.

In the configuration where the image sensor 2 is bonded to the rewiring layer 43 via the metallic bumps 5, the opening 46 forms a cavity 48 between the image sensor 2 and the support substrate 40 and gaps are formed between the plurality of metallic bumps 5 placed around the cavity 48. In the step of bonding the image sensor 2 to the rewiring layer 43, the metallic bumps 5 may be formed on the rewiring layer 43 in advance.

Thereafter, as illustrated in Fig. 5D, the step of forming a sealing resin portion 54 made of a sealing resin material is performed such that the sealing resin portion 54 is provided over the release layer 41 of the rewiring layer 43 and the opposite side to the release layer 41 and around the image sensor 2. This step is the sealing step for forming the sealing resin portion 54 made of a sealing resin material around the image sensor 2, that is, from the outside of the connecting portions formed by the metallic bumps 5 to the back side 2b of the image sensor 2 and substantially over the front-side portion 43a on the surface layer of the rewiring layer 43. The sealing resin portion 54 is a portion serving as the sealing resin portion 4 in the solid-state imaging device 1 obtained by dividing the wafer.

The sealing resin portion 54 made of, for example, thermosetting resin containing a filler is formed into a predetermined shape by molding using a mold die or spin coating or the like. The sealing resin portion 54 seals the plurality of image sensors 2 and the rewiring layer 43 into a single structure, so that a wafer structure having a predetermined shape like a disk or a rectangular plate is formed.

Thereafter, as illustrated in Fig. 6A, the step of reducing the thickness of the sealing resin portion 54 is performed from the opposite side to the rewiring layer 43 after the step of forming the sealing resin portion 54. In this step, the sealing resin portion 54 is reduced in thickness by shaving the sealing resin portion 54 from a front side 54a to a desired thickness by grinding.

The sealing resin portion 54 is reduced in thickness by, for example, a grinding attachment having a predetermined grinding wheel. By the step of reducing the thickness of the sealing resin portion 54, the layer thickness of the sealing resin portion 54 is reduced to a desired thickness T2 (see Fig. 6A) smaller than an original thickness T1 (see Fig. 5D).

In the step of reducing the thickness of the sealing resin portion 54, the sealing resin portion 54 is ground such that the sealing resin portion 54 remains on the back side of the image sensor 2, that is, a chip backside layer portion 54f is formed on the sealing resin portion 54 as a portion on the back side of the image sensor 2. However, the chip backside layer portion 54f may not be formed. If the chip backside layer portion 54f is not formed, the back side 2b of the image sensor 2 is exposed to be flush with the front side 54a.

In the step of reducing the thickness of the sealing resin portion 54, back grinding may be performed on the image sensor 2. In this case, the image sensor 2 is ground from the back side 2b to a smaller thickness during the grinding of the sealing resin portion 54. If the image sensor 2 is ground while the grinding of the sealing resin portion 54, for example, a diamond wheel is used as a grinding wheel. When the image sensor 2 is ground, for example, the back side 2b of the image sensor 2 is exposed on the grinding surface of the wafer structure as a surface flush with the front side 54a of the sealing resin portion 54, the back side 2b being formed by the semiconductor substrate 20.

Thereafter, as illustrated in Fig. 6B, the step of peeling off the support substrate 40 from the rewiring layer 43 by the release layer 41 is performed. In this step, the release layer 41 is irradiated with light having a predetermined wavelength, for example, UV light or is heated, so that the release layer 41 is easily peeled off according to a method suitable for peeling off the release layer 41 and the support substrate 40 is peeled off from the rewiring layer 43. If the release layer 41 is irradiated with light, light radiated from the support substrate 40 having transparency or translucency passes through the support substrate 40 and is emitted to the release layer 41.

After the support substrate 40 is peeled off, the step of removing the mask layer 44 is performed. The mask layer 44 is removed by, for example, etching. At this point, in order to prevent an etching solution from affecting, for example, the pixel region 21 of the image sensor 2, the opening 46 of the rewiring layer 43 can be covered in advance with a cover, for example, a glass plate.

As illustrated in Fig. 6C, the step of dicing is performed to divide the wafer structure into a plurality of chips. Specifically, the rewiring layer 43 and the sealing resin portion 54 are cut by a dicer along predetermined dicing lines that divide the wafer structure into predetermined regions for the respective image sensors 2, so that package structures are obtained as the plurality of solid-state imaging devices 1. The rewiring layer 43 and the sealing resin portion 54 that are divided by dicing serve as the rewiring layer 3 and the sealing resin portion 4 that constitute the solid-state imaging device 1.

According to the solid-state imaging device 1 of the present embodiment, the mounting surface of the solid-state imaging device 1 is placed near the pixel formation surface of the image sensor 2, so that the device can be reduced in size and height and gain speed without deteriorating the imaging capability of the image sensor 2.

The solid-state imaging device 1 has a configuration in which the rewiring layer 3 and the image sensor 2 that are electrically connected to each other via the metallic bumps 5 are sealed with the sealing resin portion 4 into a single structure. With this configuration, the image sensor 2 can be provided for the rewiring layer 3. Thus, for example, the pixel formation surface of the image sensor 2 does not need to be protected from a chemical solution or the like used for forming the rewiring layer. This can prevent the pixel formation surface from being affected by the formation of the protective film used for protecting the pixel formation surface, thereby securing the imaging capability of the image sensor 2.

Furthermore, it is assumed that the image sensor 2 is to be mounted on the rewiring layer 3 in the solid-state imaging device 1. Hence, for the configuration including the substrate on which the image sensor is to be mounted, the device can be reduced in size and height and gain speed and the tilt of the image sensor 2 or the tilt of the solid-state imaging device 1 can be suppressed with respect to the configuration where the solid-state imaging device 1 is to be mounted. Moreover, without using the substrate, an increase in cost can be suppressed when the device is reduced in height.

Furthermore, the solid-state imaging device 1 is configured such that the image sensor 2 is connected to the rewiring layer 3 from the pixel formation surface via the metallic bumps 5, achieving a larger height reduction as compared with a configuration where the image sensor 2 is connected by using wire bonding. This configuration can easily meet demands for a larger number of connecting pins with finer pitches in the image sensor 2 and downsizing of the package structure.

Moreover, according to the solid-state imaging device 1, a smaller thickness can be easily obtained by forming a fine pattern through the formation process of the rewiring layer 3. Furthermore, the rewiring layer 3 and the image sensor 2 are connected via the metallic bumps 5 or metallic posts, thereby reducing the connection length.

In the solid-state imaging device 1, the rewiring layer 3 has the peripheral region covering portion 33 and the metallic bumps 5 are provided between the image sensor 2 and the peripheral region covering portion 33. With this configuration, the rewiring layer 3 can be partially stacked on the image sensor 2 via the metallic bumps 5, thereby reducing the size of the device in a planar direction (a direction perpendicular to the stacking direction).

Moreover, in the solid-state imaging device 1, the image sensor 2 is placed in the recessed portion 4d of the sealing resin portion 4 and is provided in the range of the layer thickness of the sealing resin portion 4. Such a configuration can effectively reduce the height of the solid-state imaging device 1.

In the solid-state imaging device 1, the image sensor 2 has the step surface 24 in the peripheral region 22 and the metallic bumps 5 are provided on the step surface 24. With this configuration, the metallic bumps 5 can be formed from a position lower than the pixel region 21, so that without changing the thickness of the overall image sensor 2, the dimensions of the configuration including the mounted image sensor 2 can be reduced in the thickness direction with respect to the rewiring layer 3. Thus, the solid-state imaging device 1 can be effectively reduced in height.

In the foregoing configuration example, as for the step (inter-region step) between the pixel region 21 and the peripheral region 22, the layer thickness of the laminated structure 29 is equivalent to the size of the step because the laminated structure 29 is formed only in the pixel region 21. The inter-region step may include a layer thickness difference made by reducing (shaving) the thickness of the semiconductor substrate 20 from the top surface 20a. In other words, the configuration may secure an inter-region step by reducing the thickness of the semiconductor substrate 20 in the peripheral region 22 with respect to the thickness of the semiconductor substrate 20 in the pixel region 21, in addition to the selective formation of the laminated structure 29 in the pixel region 21.

According to the method for manufacturing the solid-state imaging device 1, the method is a so-called chip-last method that mounts the image sensor 2 on the rewiring layer 43 formed on the support substrate 40. This can reduce the influence on the pixel formation surface of the image sensor 2 and reduce the size and height of the device with higher speeds without deteriorating the imaging capability of the image sensor 2.

For example, as a method for manufacturing the solid-state imaging device 1, the process of embedding the image sensor 2 in the sealing resin material in the previous step and forming the rewiring layer 3 on the front side 2a of the image sensor 2 in the subsequent step, that is, a so-called chip-first method is proposed. In this method, the pixel formation surface of the image sensor 2 is covered with the peelable protective film for protection against a chemical solution or the like used for forming the rewiring layer 43, and the image sensor 2 is sealed with the sealing resin material with the exposed protective film. In this state, the rewiring layer 43 is formed on the sealing resin portion 54.

In the case of such a method, however, heating is performed in the step of forming the rewiring layer 43, so that the heat shrinkage of the protective film may affect the pixel formation surface or the protective film may be poorly peeled off.
The exposure of the protective film to the chemical solution used in the step of forming the rewiring layer 43 may also cause poor peeling of the protective film. If the protective film is insufficiently removed, the pixel formation surface may be contaminated with a residue. Alternatively, the protective film may be left without being removed. Also in this case, the protective film is affected in the step of forming the rewiring layer 43, so that the protective film may affect light transmission or the refractive index or the like of light and interfere with the function of the image sensor 2.

Unlike this method, the method for manufacturing the solid-state imaging device 1 first forms the rewiring layer 43 that needs heating or the step of using various solvents, bonds the image sensor 2 to the rewiring layer 43, and then integrates the rewiring layer 43 and the image sensor 2 with a sealing material. This eliminates the need for considering the protection of the image sensor 2 in the step of forming the rewiring layer 43. Hence, the problems caused by providing the protective film on the image sensor 2 can be solved, thereby minimizing the influence on the imaging capability of the image sensor 2 and reduce the size and height of the device with higher speeds.

Moreover, in the method for manufacturing the solid-state imaging device 1, the sealing resin portion 54 is reduced in thickness from the front side 54a, thereby effectively reducing the height (thickness) of the solid-state imaging device 1. In other words, the rewiring layer 3 and the image sensor 2 are integrated into a rigid form with the sealing resin material, and the sealing resin portion 54 is reduced in thickness by grinding or the like, so that the solid-state imaging device 1 can be reduced in height to a desired thickness. Moreover, in the step of reducing the thickness of the sealing resin portion 54, back grinding is performed on the image sensor 2 as well as the sealing resin portion 54 to reduce the thickness of the image sensor 2, thereby further reducing the height of the solid-state imaging device 1.

### <3. Modification example of solid-state imaging device according to first embodiment>

A modification example of the solid-state imaging device 1 according to the first embodiment will be described below.

### (First modification example)

A first modification example is a modification example of the configuration of the rewiring layer 3. As illustrated in Fig. 7, in the first modification example, the rewiring layer 3 has the inner surface 6a as wall surfaces constituting the wiring layer opening 6 such that the inner surface 6a is a tilted surface that gradually extends the opening area of the wiring layer opening 6 from the front side (front-side part 1a) to the back side (back-side part 1b) of the rewiring layer 3. The four inner surfaces 6a of the wiring layer opening 6 are tilted inward from the outside from the image sensor 2 (the lower side in Fig. 7) to the opposite side (the upper side in Fig. 7) with respect to the layer thickness direction of the rewiring layer 3, that is, in a direction that reduces the opening width of the wiring layer opening 6.

Hence, the four inner surfaces 6a tilt along the outside shapes of the sides of a square pyramid with the virtual apexes placed on the upper side. In a side cross-sectional view of Fig. 7, from the back side 3b of the rewiring layer 3 to the front side (front-side part 1a), the inner surfaces 6a form straight lines tilted from the outside near the sides 3c of the rewiring layer 3 to the inside near the wiring layer opening 6. As described above, the wiring layer opening 6 has a shape of a tapered hole as an opening shape such that the opening area gradually decreases from the lower side to the upper side. In the side cross-sectional view of Fig. 7, an angle θ1 formed with respect to a vertical line L1 along the vertical direction is, for example, about 30 to 50°.

A method for manufacturing the configuration of the first modification example will be described below. In the method for manufacturing the configuration of the first modification example, in the step of forming the rewiring layer 43 as illustrated in Fig. 8B, the rewiring layer 43 is formed such that the inner surfaces 46a as wall surfaces constituting the opening 46 are surfaces tilted to gradually extend the opening area of the opening 46 from the release layer 41 to the opposite side to the release layer 41.

In other words, in the step of forming the rewiring layer 43, the four inner surfaces 46a of the opening 46 are tilted outward from the outside from the support substrate 40 (the lower side in Fig. 8B) to the opposite side (the upper side in Fig. 8B) with respect to the layer thickness direction of the rewiring layer 43, that is, in a direction that increases the opening width of the opening 46. Thus, the four inner surfaces 46a are formed as surfaces tilted along the outside shapes of the sides of a square pyramid with the virtual apexes placed near the support substrate 40.

The opening shape of the opening 46 is easily formed into a tapered hole by using, for example, a photosensitive resin material as an insulating material of the interlayer insulating film 31 in the rewiring layer 43. If a photosensitive resin material is used as an insulating material in the step of forming the rewiring layer 43, a hole portion 46b and the connection via hole 31a that are formed on the insulating film 31x are tapered in the process of forming the opening 46 (see Fig. 8A). The four sides of the hole portion 46b are surfaces tilted in the same directions as the inner surfaces 46a of the final opening 46.

If the insulating material of the rewiring layer 43 is a so-called positive photosensitive resin material that is melted by irradiation of light, as illustrated in Figs. 8A and 8B, the intensity of light attenuates toward the depth of the bottom of a hole formed on the insulating film 31x, that is, toward the mask layer 44 forming the bottom of the hole, so that the diameter of the hole decreases. In other words, the amount of the melted insulating material gradually decreases from the front side (the upper side in Figs. 8A and 8B) to the back side (the lower side in Figs. 8A and 8B) in the irradiation direction of light (the downward direction in Figs. 8A and 8B), so that the opening width of the hole gradually decreases.

As illustrated in Fig. 8B, the opening 46 has an opening dimension M1 on the front-side portion 43a of the rewiring layer 43 and an opening dimension M2 at the bottom (on the mask layer 44) of the rewiring layer 43 such that the opening dimension M2 is smaller than the opening dimension M1. The shape of the opening 46 is tapered with respect to the irradiation direction of light. Fig. 8A illustrates a state in which the first wiring layer 32x and the first insulating film 31x of the rewiring layer 43 are formed. Fig. 8B illustrates a state in which the formation of the rewiring layer 43 is completed.

The tilt angles of the inner surfaces 6a in the wiring layer opening 6 and the inner surfaces 46a in the opening 46, that is, the taper angles of the openings (hereinafter will be also simply referred to as "taper angle") can be mainly changed by exposure conditions in the formation of the insulating film 31x.

One of the exposure conditions for adjusting the taper angles is an exposure amount (J/cm²). The larger the exposure amount, the smaller the taper angle. Thus, the taper angle can be increased by reducing the exposure amount. Therefore, as compared with the configuration obtained with the wiring layer opening 6 formed by the vertical inner surfaces 6a on the back side 3b of the rewiring layer 3 as illustrated in Fig. 3, the exposure amount is reduced in the formation of the opening 46 on the insulating film 31x in the step of forming the rewiring layer 43, thereby obtaining the configuration of the present modification example.

Specifically, in the following example, the insulating material of the rewiring layer 43 is photosensitive polyimide and the thickness of the cured rewiring layer 43 is 10 µm. In this case, if the exposure condition is broadband exposure with an exposure amount of 400 mJ/cm², the taper angle (see the angle θ1 in Fig. 7) is about 30°. Under the same condition, if the exposure amount is reduced to half, that is, 200 mJ/², the taper angle (angle θ1) is about 80 to 90°. Thus, the taper angle can be increased by reducing the exposure amount.

Another one of the exposure conditions for adjusting the taper angles is a gap (mm) between a mask used for exposure and an object to be exposed. If an exposure method in the formation of the insulating film is contact exposure using a 1:1 mask, a taper angle can be adjusted by changing the size of a gap between the mask and the insulating film. Typically, the taper angle can be increased by extending a gap between the mask and the insulating film.

Thereafter, from the state shown in Fig. 8B, the step of bonding the image sensor 2 to the rewiring layer 43 (see Fig. 5C), the step of forming the sealing resin portion 54 (Fig. 5D), the step of reducing the thickness of the sealing resin portion 54 (Fig. 6A), the step of peeling off the support substrate 40 (Fig. 6B), and the step of dividing the wafer by dicing (Fig. 6C) are performed. Thus, as illustrated in Fig. 8C, the solid-state imaging device 1 according to the present modification example is obtained.

As illustrated in Fig. 8C, in the solid-state imaging device 1, the opening widths of the lower end and the upper end of the wiring layer opening 6 are the opening dimension M1 and the opening dimension M2 in Fig. 8B. Thus, the wiring layer opening 6 has a reverse tapered shape with respect to the incident direction of light on the image sensor 2 (the downward direction in Fig. 8C).

According to the configuration of the first modification example, the wiring layer opening 6 has a reverse tapered shape, so that the generation of reflected light from the front side 2a of the image sensor 2 can be suppressed, the light having entered the pixel formation surface of the image sensor 2 through the wiring layer opening 6. Specifically, in the wiring layer opening 6 having the reverse tapered shape, the edge end portion of the opening is shaped like a hood for the front side 2a of the image sensor 2 and reflected light from the image sensor 2 is blocked by the opening edge portion of the wiring layer opening 6, so that reflected light can be suppressed. Thus, the taper angle of the wiring layer opening 6 is increased by adjusting the exposure conditions, thereby obtaining the enhanced effect of suppressing reflection.

### (Second modification example)

A second modification example is a modification example of a method for peeling off the support substrate 40 used in the method for manufacturing the solid-state imaging device 1. In the second modification example, a method for mechanically peeling off the support substrate 40 is used.

In this modification example, as the release layer 41 provided on the support substrate 40, a structure including an easy peeling layer made of an organic material or an inorganic material between metallic layers is used. Specifically, instead of the support member 42 configured with the release layer 41 on the support substrate 40, for example, an HRDP (registered trademark) (High Resolution De-bondable Panel) as a glass carrier manufactured by MITSUI MINING & SMELTING CO., Ltd. can be used. The glass carrier has a laminated structure including an adhesive layer made of copper and titanium or the like, an easy peeling layer as a release layer, and a seed layer made of copper and titanium or the like on a glass substrate serving as a support substrate.

A manufacturing method using an HRDP (registered trademark) as a glass carrier will be described below. Specifically, the step of forming the release layer 41 on the support substrate 40 (see Fig. 5A) is not necessary, the step of preparing a glass carrier as a support member including the release layer on one plate surface of the support substrate is first performed, and then the step of forming the rewiring layer 43 on the seed layer of the glass carrier is performed (Fig. 5B). Thereafter, as in the foregoing manufacturing method, the step of mounting the image sensor 2 (see Fig. 5C), the step of forming the sealing resin portion 54 (see Fig. 5D), and the step of reducing the thickness of the sealing resin portion 54 (see Fig. 6A) are performed.

Thereafter, the step of peeling off the glass carrier from the rewiring layer 43 is performed. In this step, first, cutting is performed by a dicer while a blade is placed from the sealing resin portion 54 to the depth of the easy peeling layer of the glass carrier. The glass substrate in the laminated structure of the glass carrier is then peeled off from the rewiring layer 43 by a mechanical force. Thereafter, the seed layer of the glass carrier left on the rewiring layer 43 is removed by etching, and the structure is divided to obtain package structures as the plurality of solid-state imaging device 1. As the glass carrier, a silicon wafer made of silicon may be provided instead of the glass substrate (glass wafer).

### <4. Configuration example of solid-state imaging device according to second embodiment>

Referring to Fig. 9, a configuration example of a solid-state imaging device 51 according to a second embodiment of the present technique will be described below. In the following embodiments, configurations shared with the first embodiment are denoted by the same reference numerals, and descriptions about repeated contents will be omitted as appropriate.

The solid-state imaging device 51 according to the present embodiment is different from the first embodiment in that portions around metallic bumps 5 are covered with an underfill portion 55. As illustrated in Fig. 9, the solid-state imaging device 51 includes the underfill portion 55 covering the metallic bumps 5. The underfill portion 55 is made of a material different from the sealing resin material of a sealing resin portion 4.

The underfill portion 55 is made of a resin material and is provided over at least a part of the metallic bumps 5 while filling gaps between the adjacent metallic bumps 5. The underfill portion 55 is a resin sealing portion that seals a gap between an image sensor 2 and a rewiring layer 3.

In the example of Fig. 9, the underfill portion 55 is formed to contain a plurality of metallic bumps 5 between the outer edge portion of the image sensor 2 and a peripheral region covering portion 33 of the rewiring layer 3. In other words, the underfill portion 55 includes an inner side portion 55a placed inside the metallic bumps 5 (on the right side in Fig. 9) and an outer side portion 55b placed outside the metallic bumps 5 (on the left side in Fig. 9). However, the underfill portion 55 on the metallic bumps 5 may only cover an outer surface portion of the metallic bumps 5.

The underfill portion 55 is, for example, a liquid hardening resin portion formed by curing paste or liquid resin through baking or the like. The underfill portion 55 is, for example, a capillary flow type (capillary underfill) that is formed by flowing liquid resin with a relatively low viscosity through a capillary action.

As a material of the underfill portion 55, for example, a resin material used as a mold material is used. Specific examples of the material of the underfill portion 55 are a thermosetting resin such as epoxy resin and a filler that is mainly composed of silicon oxide and is suspended in thermosetting resin. As the material of the underfill portion 55, for example, a material having lower viscosity than the material of the sealing resin portion 4 is used in view of filling gaps between the adjacent metallic bumps 5. However, the material of the underfill portion 55 is not particularly limited if the material is different from the material of the sealing resin portion 4.

A liquid resin material for the underfill portion 55 (for example, a thermosetting resin, hereinafter referred to as "underfill material") flows through a capillary action while being discharged from, for example, the nozzle of a dispenser, covers the plurality of metallic bumps 5 provided in an array or a part of the metallic bumps 5, and is applied to fill a gap between the image sensor 2 and the rewiring layer 3. Thus, the underfill portion 55 is formed into a rectangular-frame region corresponding to the shape of an overlap of the image sensor 2 and the rewiring layer 3, that is, along the opening shape of the wiring layer opening 6 in plan view.

### <5. Method for manufacturing solid-state imaging device according to second embodiment>

Referring to Fig. 10, an example of a method for manufacturing the solid-state imaging device 51 according to the second embodiment will be described below.

The method for manufacturing the solid-state imaging device 51 includes the step of forming the underfill portion 55 over the metallic bumps 5 by using a material different from the sealing resin material of the sealing resin portion 54 after the step of providing the image sensor 2 on the rewiring layer 43 and before the step of forming the sealing resin portion 54.

As illustrated in Fig. 10A, the process is shared with the first embodiment until the steps of forming the rewiring layer 43 on the support substrate 40 with the release layer 41 and the mask layer 44 interposed therebetween and providing the image sensor 2 on the rewiring layer 43 (see Figs. 5A, 5B, and 5C). After the image sensor 2 is provided on the rewiring layer 43, as illustrated in Fig. 10B, the step of forming the underfill portion 55 is performed.

In this step, the underfill material is supplied to a gap between each of the image sensors 2 and the rewiring layer 43 (hereinafter referred to as "sensor-wiring layer gap") while being discharged from the nozzle of a dispenser, which is not illustrated. At this point, for example, the underfill material is supplied to the sensor-wiring layer gap from the outer periphery of the image sensor 2.

The underfill material supplied to the sensor-wiring layer gap flows into the sensor-wiring layer gap through a capillary action, covers the plurality of metallic bumps 5, and spreads to fill the gap between the image sensor 2 and the rewiring layer 43. As the underfill material, for example, a material having a viscosity of about 10 Pa -s at room temperature is used.

After the underfill material is supplied to the sensor-wiring layer gap, baking is performed under a predetermined temperature condition in order to solidify the underfill material by vaporizing a solvent contained in the underfill material. The temperature of baking is properly set according to the underfill material or a solvent or the like contained in the underfill material. As equipment for baking, a hot plate or an oven is selected and used as appropriate. Through baking, the underfill material is solidified to form the underfill portion 55.

After the underfill portion 55 is formed, the step of forming the sealing resin portion 54 is performed as illustrated in Fig. 10C. Thereafter, as in the first embodiment, the step of reducing the thickness of the sealing resin portion 54 (Fig. 6A), the step of peeling off the support substrate 40 (see Fig. 6B), and the step of dividing the wafer by dicing (Fig. 6C) are performed. Thus, the solid-state imaging device 51 is obtained.

According to the solid-state imaging device 51 of the present embodiment and the method for manufacturing the same, the following effects are obtained in addition to the effects obtained by the solid-state imaging device 1 of the first embodiment and the method for manufacturing the same. Specifically, the underfill portion 55 is provided between the peripheral region 22 of the image sensor 2 and the peripheral region covering portion 33 of the rewiring layer 3, thereby preventing the sealing resin material from passing between the image sensor 2 and the rewiring layer 43 and entering the pixel region 21 of the image sensor 2 when the sealing resin portion 54 is formed. Thus, the functions of the image sensor 2 can be obtained.

With the configuration including the underfill portion 55, the underfill portion 55 can protect and reinforce the metallic bumps 5 provided between the image sensor 2 and the rewiring layer 3 and the connecting portions formed by the metallic bumps 5. Thus, the bonding strength of the image sensor 2 to the rewiring layer 3 can be improved.

### <6. Modification examples of solid-state imaging device according to second embodiment>

Modification examples of the solid-state imaging device 51 according to the second embodiment will be described below. The following modification example relates to a configuration for preventing the sealing resin material from passing between the image sensor 2 and the rewiring layer 43 and entering the pixel region 21 when the sealing resin portion 54 is formed.

### (First modification example)

As illustrated in Fig. 11, in the first modification example, the underfill portion 55 provided between the peripheral region 22 of the image sensor 2 and the peripheral region covering portion 33 of the rewiring layer 3 is provided over the edge portion of the image sensor 2 and the outside of the metallic bumps 5.

The underfill portion 55 has an outer lower portion 55c extended from the edge portion of the back side 2b to cover the side portion 2c and the edge portion of the front side 2a (step surface 24) on the image sensor 2. Moreover, on the metallic bumps 5, the underfill portion 55 has an outer side portion 55b placed outside the metallic bumps 5 and does not have an inner side portion 55a (see Fig. 9).

The underfill portion 55 may be formed in the form of the present modification example. The shape of the underfill portion 55 can be properly changed by adjusting, for example, a discharge pressure of the underfill material from a nozzle, the application region of the underfill material, and the viscosity of the underfill material. Also in the configuration of the present modification example, the underfill portion 55 can prevent the sealing resin material from entering the pixel region 21 of the image sensor 2 when the sealing resin portion 54 is formed.

### (Second modification example)

In a second modification example, a partition portion for separating the space for placement of the metallic bumps 5 and a space for the pixel region 21 is provided near the pixel region 21 with respect to the metallic bumps 5 and between the peripheral region covering portion 33 of the rewiring layer 3 and the peripheral region 22 of the image sensor 2.

As illustrated in Fig. 12, in the present modification example, the partition portion is formed by a part of the interlayer insulating film 31 of the rewiring layer 3. Specifically, in the present modification example, the rewiring layer 3 has a partition wall portion 56 as a part of the interlayer insulating film 31 on the opening edge portion of the wiring layer opening 6. The partition wall portion 56 is a partition portion that separates the space for placement of the metallic bumps 5 and the space for the pixel region 21.

The partition wall portion 56 is placed inside the metallic bumps 5 (on the right side in Fig. 12) and is formed to protrude downward on the opening edge portion of the wiring layer opening 6. The partition wall portion 56 has the inner wall surface that forms the lower portion of the inner surface 6a of the wiring layer opening 6, is formed into a protruding portion having a predetermined thickness, and has a linear shape or is shaped like a rectangular frame along the outside shape of the wiring layer opening 6.

The partition wall portion 56 is formed over the height of the metallic bumps 5 or substantially over the range of the height in the vertical direction. The partition wall portion 56 has a lower end face 56a near the step surface 24, which is a part of the front side 2a of the image sensor 2, with a small clearance between the lower end face 56a and the step surface 24. The clearance between the lower end face 56a and the step surface 24 does not allow the sealing resin material from entering the pixel region 21 from the outside (the left side in Fig. 12) in relation to the viscosity or the like of the sealing resin material of the sealing resin portion 4.

The partition wall portion 56 is formed by the lower layer portion of the interlayer insulating film 31 constituting the rewiring layer 3, the lower layer portion being close to the surface layer of the rewiring layer 43 in the manufacturing process of the rewiring layer 3. In the lower layer portion of the interlayer insulating film 31, the partition wall portion 56 is formed with a recessed portion 57 serving as the space for placement of the metallic bumps 5. The recessed portion 57 is opened on the lower side and has the bottom at the upper surface, a wall surface on the inside, and a wall surface on the outside. The wall surface inside the recessed portion 57 serves as an outer wall surface 56b of the partition wall portion 56. Outside the recessed portion 57, a lower layer portion 58 is formed as the same layer portion as the partition wall portion 56.

The recessed portion 57 is formed into, for example, a groove portion like a linear shape or a rectangular frame along the outside shape of the partition wall portion 56. In the rewiring layer 3, the recessed portion 57 is a portion exposing the lower electrodes 32a to which the upper sides of the metallic bumps 5 are connected via the plating layer 35. Moreover, the recessed portion 57 is formed to include the formation region of the pad electrodes 27 to which the lower sides of the metallic bumps 5 are connected in plan view.

The opening side of the recessed portion 57 is partially closed by the edge portion of the image sensor 2 and forms a space portion 59 around the metallic bumps 5 along with the image sensor 2. The recessed portion 57 is formed to be opened on the outer side of the space portion 59 in relation to the edge portion of the image sensor 2. A gap 60 is formed between the interlayer insulating film 31 of the rewiring layer 3 and the edge portion of the image sensor 2.

The recessed portion 57 is filled with the sealing resin material of the sealing resin portion 4. The metallic bumps 5 located in the recessed portion 57 are embedded in the sealing resin portion 4. Specifically, in the present modification example, the sealing resin portion 4 has a recessed portion filling portion 4e that fills the recessed portion 57 and covers the overall connecting portions of the metallic bumps 5.

For example, the configuration of the present modification example is obtained by the following manufacturing method. Specifically, in the step of forming the rewiring layer 43, the layer portion of the insulating film 31x is formed near the surface layer with respect to the lower electrodes 32a and the recessed portion 57 is formed to expose the lower electrodes 32a, so that the partition wall portion 56 is formed as a relatively protruding portion. If the insulating film is made of a photosensitive resin material, for example, the recessed portion 57 is formed by a photolithography process. If the insulating film is made of a non-photosensitive resin material, for example, the recessed portion 57 is formed by using a laser or the like.

In the step of forming the sealing resin portion 54, the sealing resin material is charged into the recessed portion 57 through the gap 60. At this point, the partition wall portion 56 blocks the sealing resin material.

As described above, the partition wall portion 56 is formed inside the metallic bumps 5 by using the insulating material of the rewiring layer 3, thereby preventing the sealing resin material from entering the pixel region 21 of the image sensor 2.

### (Third modification example)

In a third modification example, as in the second modification example, a partition portion for separating the space for placement of the metallic bumps 5 and a space for the pixel region 21 is provided. As illustrated in Fig. 13, in the present modification example, the partition portion is formed by a member different from the rewiring layer 3 and the image sensor 2, on the underside of the opening edge portion of the wiring layer opening 6 on the rewiring layer 3. Specifically, in the present modification example, the solid-state imaging device 51 has a partition wall 61 on the underside of the opening edge portion of the wiring layer opening 6, the partition wall 61 serving as a partition portion that separates the space for placement of the metallic bumps 5 and the space for the pixel region 21.

The partition wall 61 is placed inside the metallic bumps 5 (on the right side in Fig. 13) and is formed to protrude downward on the opening edge portion of the wiring layer opening 6. The partition wall 61 has an inner wall surface 61b that forms the lower portion of the inner surface 6a of the wiring layer opening 6, is formed into a protruding portion having a predetermined thickness, and has a linear shape or is shaped like a rectangular frame along the outside shape of the wiring layer opening 6.

The partition wall 61 is provided over the height of the metallic bumps 5 or substantially over the range of the height in the vertical direction. The partition wall 61 has a lower end face 61a near the step surface 24, which is a part of the front side 2a of the image sensor 2, with a small clearance between the lower end face 61a and the step surface 24. The clearance between the lower end face 61a and the step surface 24 does not allow the sealing resin material from entering the pixel region 21 from the outside (the left side in Fig. 13) in relation to the viscosity or the like of the sealing resin material of the sealing resin portion 4.

In the manufacturing method for the configuration of the present modification example, the rewiring layer 43 is formed on the support substrate 40, and then the partition wall 61 is provided along the opening edge portion of each of the openings 46 of the rewiring layer 43. The material of the partition wall 61 is, for example, a thermosetting resin such as epoxy resin, a photosensitive adhesive of a UV (ultraviolet) curing resin that is an acrylic resin, or an admixture thereof. However, if the material of the interlayer insulating film 31 of the rewiring layer 3 is a photosensitive material, a non-photosensitive material is used as the material of the partition wall 61.

The partition wall 61 is formed by, for example, applying a material through a dispenser or performing patterning using a photolithography technique on the front-side portion 43a (see Fig. 5B) of the rewiring layer 43. However, the partition wall 61 may be provided by bonding, for example, a frame-like structure onto the rewiring layer 43 with an adhesive or the like, the structure being made of, for example, ceramics such as glass, inorganic materials such as metals and silicon, or resin materials.

Moreover, in the step of forming the sealing resin portion 54, the partition wall 61 blocks the sealing resin material and the connecting portions formed by the metallic bumps 5 are covered with the sealing resin material.

As described above, the partition wall 61 is formed inside the metallic bumps 5 by using a material different from the insulating material of the rewiring layer 3, thereby preventing the sealing resin material from entering the pixel region 21 of the image sensor 2.

In addition to the foregoing modification examples, for example, dummy bumps made of the same metallic material as the metallic bumps 5 may be provided inside the metallic bumps 5, as a configuration for preventing the sealing resin material from entering the pixel region 21. In this case, the dummy bumps are located to close gaps between the adjacent metallic bumps 5.

Considering the configurations of the first embodiment and the second embodiment, the sealing resin material of the sealing resin portion 4 or the underfill material is disposed around the metallic bumps 5 between the peripheral region 22 of the image sensor 2 and the peripheral region covering portion 33 of the rewiring layer 3. Moreover, gaps are present around the metallic bumps 5 depending upon the formation pattern of the sealing resin portion 4.

### <7. Configuration example of solid-state imaging device according to third embodiment>

Referring to Fig. 14, a configuration example of a solid-state imaging device 71 according to a third embodiment of the present technique will be described below.

The solid-state imaging device 71 according to the present embodiment is different from the first embodiment in that a second rewiring layer 73 is provided on a surface of a sealing resin portion 4 in addition to a rewiring layer 3. Specifically, the solid-state imaging device 71 further includes the second rewiring layer 73 that is provided near a back side 2b of an image sensor 2 with respect to the image sensor 2 and the sealing resin portion 4 and is electrically connected to the rewiring layer 3 serving as a first rewiring layer. If the rewiring layer 3 is a front-side rewiring layer in the solid-state imaging device 71, the second rewiring layer 73 serves as a back-side rewiring layer.

In the solid-state imaging device 71, the back side 2b of the image sensor 2 and an undersurface 4b of the sealing resin portion 4 form undersides flush with each other. The second rewiring layer 73 is provided on the undersides. On the second rewiring layer 73, a contact surface with the image sensor 2 and the sealing resin portion 4 is a top surface 73a. Like the rewiring layer 3, the second rewiring layer 73 is formed as a laminated wiring layer including a plurality of wiring layers 82 stacked via an interlayer insulating film 81.

The uppermost layer portion of the wiring layer 82 constituting the second rewiring layer 73 forms an upper electrode portion 82a to which the rewiring layer 3 is electrically connected. The upper electrode portion 82a is an electrode portion that is formed while being exposed on top surface 73a of the second rewiring layer 73. In the example of Fig. 14, the upper electrode portions 82a are formed on both end portions of the solid-state imaging device 71.
The number of upper electrode portions 82a and the layout thereof are not particularly limited.

The wiring layer 82 provided in the second rewiring layer 73 is formed to include layered portions including the upper electrode portion 82a and a connecting portion vertically connecting the layered portions. The connecting portion is a portion formed in a connection via hole 81a that is formed in the layer thickness direction in the interlayer insulating film 81. The second rewiring layer 73 may be a wiring layer having a single-layer structure.

The upper electrode portions 82a of the wiring layer 82 are electrically connected to the rewiring layer 3 via metallic bumps 85 serving as connecting portions provided in the layer of the sealing resin portion 4. The rewiring layer 3 has second lower electrodes 32c as portions to which the metallic bumps 85 are connected. The second lower electrodes 32c are formed as electrode portions in the same layer as the lower electrodes 32a to which the metallic bumps 5 are connected. The second lower electrodes 32c are provided at multiple points according to the layout of the metallic bumps 85.

The metallic bumps 85 are, for example, Au stud bumps, solder ball bumps, or Au-Ag alloy bumps. The connecting portions between the rewiring layer 3 and the second rewiring layer 73 may be, for example, metallic posts such as Cu pillars.

### <8. Method for manufacturing solid-state imaging device according to third embodiment>

Referring to Figs. 15 and 16, an example of a method for manufacturing the solid-state imaging device 71 according to the third embodiment will be described below.

The method for manufacturing the solid-state imaging device 71 includes, after the step of forming a sealing resin portion 54, the step of forming the second rewiring layer 73, which is electrically connected to the rewiring layer 3, near a back side 2b of the image sensor 2 with respect to the image sensor 2 and the sealing resin portion 54.

The process is shared with the first embodiment until the step of forming a rewiring layer 43 on a support substrate 40 with a release layer 41 and a mask layer 44 interposed therebetween (see Figs. 5A and 5B). However, as illustrated in Fig. 15A, second lower electrodes 32c to which metallic bumps 85 are connected are formed as the wiring layer of the outermost layer (the uppermost layer in Fig. 15A) in the rewiring layer 43, along with lower electrodes 32a to which the metallic bumps 5 are connected. On the second lower electrodes 32c, a plating layer (not illustrated) formed by Au plating or the like according to, for example, a combination of the materials of the second lower electrodes 32c and the metallic bumps 85.

Thereafter, as illustrated in Fig. 15B, the step of forming the metallic bumps 85 on the second lower electrodes 32c is performed. In the step of forming the metallic bumps 85, solder bumps as the metallic bumps 85 are formed on the second lower electrodes 32c by using, for example, a wire bonding device. If metallic posts such as Cu pillars are used instead of the metallic bumps 85, for example, cylindrically protruding portions made of materials such as Cu and a Cu alloy are formed as the metallic posts on the second lower electrodes 32c by plating, sputtering, or vapor deposition or the like.

If Cu posts are formed instead of the metallic bumps 85, for example, the following steps are performed. First, a resist for forming wiring layers 32 of the rewiring layer 43 is peeled off, a seed layer is formed, and then patterning is performed on a resist for forming Cu posts. Thereafter, the Cu posts with a desired height are formed on the seed layer by plating, the resist is peeled off, and then the seed layer is removed by etching or the like.

Subsequently, as in the first embodiment, the step of mounting the image sensor 2 on the rewiring layer 43 is performed as illustrated in Fig. 15C, and then the step of forming the sealing resin portion 54 by using a sealing resin material is performed as illustrated in Fig. 16A. In the step of forming the sealing resin portion 54, the sealing resin portion 54 is formed such that the metallic bumps 85 are embedded in the sealing resin material.

After the image sensor 2 and the rewiring layer 43 are sealed with the sealing resin portion 54, as illustrated in Fig. 16B, the step of reducing the thickness of the sealing resin portion 54 to a desired thickness from a front side 54a is performed by grinding. In this step, the sealing resin portion 54 is ground until the metallic bumps 85 are exposed at least on the front side 54a of the sealing resin portion 54. In the example of Fig. 16B, a back side 2b of the image sensor 2 is also exposed. However, a chip backside layer portion 54f (see Fig. 6A) may be formed on the sealing resin portion 54 without exposing the back side 2b of the image sensor 2.

In the grinding of the sealing resin portion 54, the metallic bumps 85 are ground with the sealing resin portion 54 such that a sufficient area is exposed to obtain an electrical connection to the second rewiring layer 73. Thus, on the metallic bump 85, an end face 85a forming a flat surface 86 flush with the front side 54a of the sealing resin portion 54 is formed on the opposite side (the upper side in Fig. 16B) to the connection side to the second lower electrode 32c. The flat surface 86 is a surface on which the second rewiring layer 73 is formed. In the example of Fig. 16B, the flat surface 86 is formed by the front side 54a of the sealing resin portion 54, the end faces 85a of the metallic bumps 85, and the back side 2b of the image sensor 2.

As illustrated in Fig. 16C, a second rewiring layer 93 is formed on the flat surface 86. The second rewiring layer 93 is a part constituting the second rewiring layer 73 in the solid-state imaging device 71 obtained by dividing a wafer. In the step of forming the second rewiring layer 93, for example, known methods such as a semi-additive process are used as in the step of forming the rewiring layer 43 according to the first embodiment, so that the second rewiring layer 93 having a laminated structure of the interlayer insulating film 81 and the wiring layers 82 is formed.

Thereafter, as in the first embodiment, the step of peeling off the support substrate 40 (see Fig. 6B) and the step of dividing the wafer by dicing (Fig. 6C) are performed. Thus, as illustrated in Fig. 14, the solid-state imaging device 71 is obtained with the rewiring layer 3 as a front-side rewiring layer and the second rewiring layer 73 as a back-side rewiring layer.

According to the solid-state imaging device 71 of the present embodiment and the method for manufacturing the same, the following effects are obtained in addition to the effects obtained by the solid-state imaging device 1 of the first embodiment and the method for manufacturing the same. According to the configuration of the present embodiment, in addition to the rewiring layer 3, the second rewiring layer 73 is provided for the rewiring layer 3 via the sealing resin portion 54, achieving the multiple rewiring layers. For example, the provision of an external connection terminal on the surface layer of the second rewiring layer 73 (the lower side in Fig. 14) can connect an electronic component, e.g., a flexible substrate to the second rewiring layer 73.

Moreover, the second rewiring layer 73 can supplement the number of wiring layers, thereby reducing the number of wiring layers formed on the support substrate 40, e.g., a glass plate with the release layer 41 or the like interposed therebetween in the step of forming the rewiring layer 43. Thus, warpage on the rewiring layer 43 can be reduced in the manufacturing process, and warpage can be further reduced over the package of the completed solid-state imaging device 71.

### <9. Configuration example of electronic equipment>

Referring to Fig. 17, an application example of the solid-state imaging devices according to the foregoing embodiments will be described below.

The solid-state imaging device according to the present technique can be applied to a general electronic device in which a solid-state imaging element is used in an image capturing unit (a photoelectric conversion unit), such as a camera device such as a digital still camera or a video camera, a portable terminal device that has an imaging function, or a copy machine in which a solid-state imaging element is used in an image reading unit. The solid-state imaging device may be formed as a one-chip or may be formed as a module in which an imaging unit and a signal processing unit or an optical system are collectively packaged with an imaging function.

As illustrated in Fig. 17, a camera device 200 as an electronic device includes an optical unit 202, a solid-state imaging device 201, a DSP (Digital Signal Processor) circuit 203, a frame memory 204, a display unit 205, a recording unit 206, an operation unit 207, and a power supply unit 208. The DSP circuit 203, the frame memory 204, the display unit 205, the recording unit 206, the operation unit 207, and the power supply unit 208 are properly connected to one another via a connection line 209, e.g., a bus line. For example, the solid-state imaging device 201 is the solid-state imaging device 1 according to the first embodiment.

The optical unit 202 including a plurality of lenses captures incident light (image light) from a subject and forms an image on the imaging surface of the solid-state imaging device 201. The solid-state imaging device 201 converts the amount of incident light, for which an image is formed on the imaging surface by the optical unit 202, into an electric signal for each pixel and outputs the electric signal as a pixel signal.

The display unit 205 includes, for example, a panel-type display device such as a liquid crystal panel or an organic EL (Electro Luminescence) panel, and displays a moving image or a still image captured by the solid-state imaging device 201. The recording unit 206 records the moving image or the still image captured by the solid-state imaging device 201 in a recording medium such as a hard disk or a semiconductor memory.

The operation unit 207 issues operation commands for various functions of the camera device 200 in response to user operations. The power supply unit 208 properly supplies various power supplies serving as operation power supplies for the DSP circuit 203, the frame memory 204, the display unit 205, the recording unit 206, and the operation unit 207 to these targets of supply.

According to the camera device 200 configured thus, the solid-state imaging device 201 can be reduced in size and height and can gain speed without deteriorating the imaging capability of the image sensor 2. Thus, a proper operating state can be kept and desired characteristics can be obtained in the camera device 200, and the device can be compact in size.

The descriptions of the foregoing embodiments are merely examples of the present technique, and the present technique is not limited to the foregoing embodiments. For this reason, it is needless to say that various changes aside from the foregoing embodiments can be made according to the design and the like within the scope of the technical idea of the present disclosure. In addition, the advantages described in the present disclosure are merely exemplary and are not limited, and other advantages may be obtained. The configurations of the foregoing embodiments and the modification examples can be combined as appropriate.

In the foregoing embodiments, the image sensor 2 has a step between the pixel region 21 and the peripheral region 22 on the front side 2a serving as a pixel formation surface. An imaging element according to the present technique is not limited to this configuration. The imaging element according to the present technique may be configured with a flat surface without a step on the pixel formation surface.

The present technique can be configured as follows:
(1) An imaging device including: an imaging element having a pixel region and a peripheral region on the front side, the pixel region including multiple pixels, the peripheral region surrounding the pixel region;
   a rewiring layer that is provided on the front side of the imaging element and has an opening formed through a region including the pixel region;
   a sealing resin portion that is made of a sealing resin material and is provided to cover a portion around the imaging element and the back side of the rewiring layer; and a connecting portion that is provided on the peripheral region of the imaging element and electrically connects the imaging element and the rewiring layer.
(2) The imaging device according to (1), wherein the rewiring layer includes a peripheral region covering portion that covers at least a part of the peripheral region of the imaging element in plan view, and
   the connecting portion is provided between the imaging element and the peripheral region covering portion.
(3) The imaging device according to (1) or (2), wherein the imaging element is placed in a recessed portion formed on the sealing resin portion and is provided in the range of the layer thickness of the sealing resin portion.
(4) The imaging device according to any one of (1) to (3), further including an underfill portion that is made of a material different from the sealing resin material and covers the connecting portion.
(5) The imaging device according to any one of (1) to (4), wherein the imaging element has a step surface with a step lower than the pixel region in the peripheral region, and the connecting portion is provided on the step surface.
(6) The imaging device according to any one of (1) to (5), wherein the rewiring layer is formed such that a wall surface constituting the opening is a surface tilted to gradually extend the opening area of the opening from the front side to the back side of the rewiring layer.
(7) The imaging device according to any one of (1) to (5), wherein a partition portion for separating a space for placement of the connecting portion and a space for the pixel region is provided near the pixel region with respect to the connecting portion and between the rewiring layer and the imaging element.
(8) The imaging device according to any one of (1) to (7), further including a second rewiring layer that is provided near the back side of the imaging element with respect to the imaging element and the sealing resin portion and is electrically connected to the rewiring layer.
(9) An electronic device including an imaging device including: an imaging element having a pixel region and a peripheral region on the front side, the pixel region including multiple pixels, the peripheral region surrounding the pixel region;
   a rewiring layer that is provided on the front side of the imaging element and has an opening formed through a region including the pixel region;
   a sealing resin portion that is made of a sealing resin material and is provided to cover a portion around the imaging element and the back side of the rewiring layer; and a connecting portion that is provided on the peripheral region of the imaging element and electrically connects the imaging element and the rewiring layer.
(10) A method for manufacturing an imaging device, the method including: preparing a support member having a release layer on one plate surface of a support substrate; forming a rewiring layer having an opening on the release layer, the opening exposing the release layer;
   providing the imaging element on the rewiring layer such that the imaging element covers the opening and is electrically connected to the rewiring layer while the front side of the imaging element faces the release layer;
   forming a sealing resin portion made of a sealing resin material such that the sealing resin portion is provided over the release layer of the rewriting layer and the opposite side to the release layer and around the imaging element; and
   peeling off the support substrate from the rewiring layer by the release layer.
(11) The method for manufacturing an imaging device according to (10), further including reducing the thickness of the sealing resin portion from the opposite side to the rewiring layer after forming the sealing resin portion.
(12) The method for manufacturing an imaging device according to (10) or (11), further including forming an underfill portion over the connecting portion by using a material different from the sealing resin material after providing the imaging element and before forming the sealing resin portion.
(13) The method for manufacturing an imaging device according to any one of (10) to (12), wherein in the forming of the rewiring layer, the rewiring layer is formed such that a wall surface constituting the opening is a surface tilted to gradually extend the opening area of the opening from the release layer to the opposite side to the release layer.
(14) The method for manufacturing an imaging device according to any one of (10) to (13), further including, after forming the sealing resin portion, forming a second rewiring layer near the back side of the imaging element with respect to the imaging element and the sealing resin portion, the second rewiring layer being electrically connected to the rewiring layer.

### [Reference Signs List]

1 Solid-state imaging device (imaging device)
1a Front-side part
1b Back-side part
2 Image sensor (imaging element)
2a Front side
3 Rewiring layer
3b Back side
4 Sealing resin portion
4d Recessed portion
5 Metallic bump (connecting portion)
6 Wiring layer opening
6a Inner surface (wall surface)
7 External connection terminal
20 Semiconductor substrate
21 Pixel region
22 Peripheral region
23 Pixel
24 Step surface
31 Interlayer insulating film
32 Wiring layer
32a Lower electrode
32c Second lower electrode
33 Peripheral region covering portion
40 Support substrate
40a Top surface
41 Release layer
42 Support member
43 Rewiring layer
46 Opening
46a Inner surface (wall surface)
51 Solid-state imaging device (imaging device)
54 Sealing resin portion
54a Front side
55 Underfill portion
56 Partition wall portion (partition portion)
61 Partition wall (partition portion)
71 Solid-state imaging device (imaging device)
73 Second rewiring layer
85 Metallic bump
93 Second rewiring layer
200 Camera device (electronic device)
201 Solid-state imaging device (imaging device)

## Claims

1. An imaging device comprising: an imaging element having a pixel region and a peripheral region on the front side, the pixel region including multiple pixels, the peripheral region surrounding the pixel region;
a rewiring layer that is provided on the front side of the imaging element and has an opening formed through a region including the pixel region;
a sealing resin portion that is made of a sealing resin material and is provided to cover a portion around the imaging element and a back side of the rewiring layer; and
a connecting portion that is provided on the peripheral region of the imaging element and electrically connects the imaging element and the rewiring layer.

2. The imaging device according to claim 1, wherein the rewiring layer includes a peripheral region covering portion that covers at least a part of the peripheral region of the imaging element in plan view, and
the connecting portion is provided between the imaging element and the peripheral region covering portion.

3. The imaging device according to claim 1, wherein the imaging element is placed in a recessed portion formed on the sealing resin portion and is provided in a range of a layer thickness of the sealing resin portion.

4. The imaging device according to claim 1, further comprising an underfill portion that is made of a material different from the sealing resin material and covers the connecting portion.

5. The imaging device according to claim 1, wherein the imaging element has a step surface with a step lower than the pixel region in the peripheral region, and
the connecting portion is provided on the step surface.

6. The imaging device according to claim 1, wherein the rewiring layer is formed such that a wall surface constituting the opening is a surface tilted to gradually extend an opening area of the opening from a front side to the back side of the rewiring layer.

7. The imaging device according to claim 1, wherein a partition portion for separating a space for placement of the connecting portion and a space for the pixel region is provided near the pixel region with respect to the connecting portion and between the rewiring layer and the imaging element.

8. The imaging device according to claim 1, further comprising a second rewiring layer that is provided near a back side of the imaging element with respect to the imaging element and the sealing resin portion and is electrically connected to the rewiring layer.

9. An electronic device comprising an imaging device including: an imaging element having a pixel region and a peripheral region on the front side, the pixel region including multiple pixels, the peripheral region surrounding the pixel region;
a rewiring layer that is provided on the front side of the imaging element and has an opening formed through a region including the pixel region;
a sealing resin portion that is made of a sealing resin material and is provided to cover a portion around the imaging element and a back side of the rewiring layer; and
a connecting portion that is provided on the peripheral region of the imaging element and electrically connects the imaging element and the rewiring layer.

10. A method for manufacturing an imaging device, the method comprising: preparing a support member having a release layer on one plate surface of a support substrate;
forming a rewiring layer having an opening on the release layer, the opening exposing the release layer;
providing the imaging element on the rewiring layer such that the imaging element covers the opening and is electrically connected to the rewiring layer while the front side of the imaging element faces the release layer;
forming a sealing resin portion made of a sealing resin material such that the sealing resin portion is provided over the release layer of the rewriting layer and an opposite side to the release layer and around the imaging element; and
peeling off the support substrate from the rewiring layer by the release layer.

11. The method for manufacturing an imaging device according to claim 10, further comprising reducing a thickness of the sealing resin portion from an opposite side to the rewiring layer after forming the sealing resin portion.

12. The method for manufacturing an imaging device according to claim 10, further comprising forming an underfill portion over the connecting portion by using a material different from the sealing resin material after providing the imaging element and before forming the sealing resin portion.

13. The method for manufacturing an imaging device according to claim 10, wherein in the forming of the rewiring layer, the rewiring layer is formed such that a wall surface constituting the opening is a surface tilted to gradually extend an opening area of the opening from the release layer to the opposite side to the release layer.

14. The method for manufacturing an imaging device according to claim 10, further comprising, after forming the sealing resin portion, forming a second rewiring layer near the back side of the imaging element with respect to the imaging element and the sealing resin portion, the second rewiring layer being electrically connected to the rewiring layer.
